# EUROPEAN PATENT APPLICATION

(11) **EP 4 495 301 A1**
(43) Date of publication of application: **22.01.2025**
(21) Application number: 23770699.9
(22) Date of filing: 10.03.2023
(51) Int. Cl.: C30B 29/38, C30B 25/20, H01L 21/20, H01L 21/338, H01L 29/778, H01L 29/812

(54) **GAN EPITAXIAL SUBSTRATE**

(30) Priority: 14.03.2022 JP 2022039628; 14.03.2022 JP 2022039629
(71) Applicant: Mitsubishi Chemical Corporation, Tokyo 100-8251 (JP)
(72) Inventor: ISO, Kenji, Tokyo 100-8251 (JP); TOKUMITSU, Youji, Tokyo 100-8251 (JP)
(74) Representative: Hoffmann Eitle
(86) International application number: PCT/JP2023/009462
(87) International publication number: WO 2023/176744

(57) **Abstract**

The present invention relates to a GaN epitaxial substrate including a GaN substrate and a GaN buffer layer epitaxially grown on the GaN substrate. The GaN epitaxial substrate includes a point A present in the GaN substrate or the GaN buffer layer, and a point B present in the GaN buffer layer and having a Fe concentration of 1/100 of a Fe concentration of the point A. A distance between the point A and the point B is 0.2 µm or less.

## Description

### TECHNICAL FIELD

The present invention relates to a GaN epitaxial substrate.

### BACKGROUND ART

In recent years, a GaN-based high electron mobility transistor (HEMT) (hereinafter, may be referred to as "GaN-HEMT") has been actively developed for radio-frequency devices of several tens of GHz to several hundreds of GHz. Silicon, silicon carbide (SiC), GaN, and the like have been studied as substrates used for a GaN-HEMT, and a GaN-HEMT using a GaN substrate is expected to have excellent performance compared with a GaN-HEMT using another substrate. The GaN-HEMT repeatedly turns a current on and off at the radio frequency, but ideally, it is required that no current flows when the device is in an OFF state. Therefore, in the case where a GaN substrate is used for the GaN-HEMT, the GaN substrate is preferably made semi-insulating.

As a method for making a GaN substrate semi-insulating, a method for doping a GaN substrate with a transition metal element and a Group 12 element has been known. The transition metal element and the Group 12 element act as acceptors, and therefore, there is an effect of reducing a concentration of a carrier in the GaN substrate by compensating for a background donor unintentionally introduced into the GaN substrate. The transition metal element and the Group 12 elements are referred to as compensation impurities.

For example, in the aspect described in Non-Patent Literature 1, a GaN substrate doped with Fe or Mn as a compensation impurity is obtained. In the aspects described in Patent Literatures 1 to 3, which are not examples using a GaN substrate, a GaN buffer layer is doped with Fe as a compensation impurity.

### CITATION LIST

### PATENT LITERATURE

Patent Literature 1: JP2016-511545A
Patent Literature 2: JP2018-041786A
Patent Literature 3:JP2017-085054A

### NON-PATENT LITERATURE

Non Patent Literature 1: M Iwinska et al., Iron and manganese as dopants used in the crystallization of highly resistive HVPE-GaN on native seeds, Japanese Journal of Applied Physics, Vol. 58 SC1047, 2019

### SUMMARY OF INVENTION

### TECHNICAL PROBLEM

Initially, in order to obtain a GaN substrate that is preferably used for a GaN-HEMT, the present inventors have studied a GaN substrate doped with Fe.

In this process, it has been confirmed that Fe can diffuse in a GaN buffer layer in the case where a HEMT structure is formed using the GaN substrate doped with Fe. In particular, when Fe diffuses to a region where a two-dimensional electron gas (hereinafter, may be referred to as "2DEG"), which is an electron channel of the HEMT device, is generated, the performance of the transistor deteriorates due to a decrease in electron mobility, and a high electron mobility operation in the HEMT may not be implemented.

Accordingly, it is necessary to restrict or prevent diffusion of Fe to a region where the 2DEG is generated.

Accordingly, an object of the present invention is to provide a GaN epitaxial substrate that contains Fe as a compensation impurity, prevents diffusion of Fe, and is good in the degree of freedom in design and manufacturing cost of a device.

Although Patent Literature 1 focuses on solving the problem of a large number of traps due to the memory effect specific to doping with Fe, the problem of diffusion of Fe in a solid is not mentioned at all, and the problem caused by the diffusion of Fe has not been recognized. In Patent Literature 1, residual Fe after the stop of doping with Fe and unintended doping itself of residual Fe are maintained. Therefore, a GaN epitaxial substrate in which diffusion of Fe to a region where a 2DEG is generated is restricted has not been obtained.

In Patent Literature 2, in order to restrict diffusion of Fe, a GaN buffer layer not doped with Fe is grown on a GaN buffer layer doped with Fe (Fe-doped GaN buffer layer) at a temperature lower than a growth temperature of the Fe-doped GaN buffer layer. Namely, in Patent Literature 2, the diffusion of Fe is restricted by lowering the growth temperature of the GaN buffer layer.

However, the crystal growth temperature is determined by the growth conditions of a metal organic chemical vapor deposition (MOCVD) method, and therefore, it is not easy to change only the temperature. There is a certain limitation to the growth temperature from the viewpoint of obtaining a good crystal or the like, and therefore, there is actually a limit to the reduction in a Fe concentration. In Patent Literature 2, residual Fe after the stop of doping with Fe and unintended doping itself of residual Fe are also maintained. As a result, it cannot be said that diffusion of Fe can be sufficiently restricted in Patent Literature 2.

As a result of lowering the growth temperature, the GaN buffer layer on the Fe-doped GaN buffer layer contains C at a high concentration of 1 × 10¹⁹ atoms/cm³, and there are concerns about leakage current caused by C itself and reduction in crystal quality.

Patent Literature 3 discloses a semiconductor device in which a channel layer doped with Al at a constant concentration is formed, on a GaN buffer layer doped with Fe, in order to restrict diffusion of Fe. However, it can not be said that diffusion of Fe cannot be sufficiently restricted in Patent Literature 3.

In addition to the methods disclosed in Patent Literatures 1 to 3, a method for reducing an amount of Fe reaching a region where a 2DEG is generated and reducing a Fe concentration of the region by forming a Fe-doped GaN buffer layer and then providing a sufficiently thick undoped GaN buffer layer thereon is also conceivable in view of the fact that the Fe concentration decreases as the diffusion distance increases. However, in this method, as the diffusion distance is increased, a very thick undoped GaN buffer layer is required. Thus, the degree of freedom in design of the HEMT device is impaired and the manufacturing cost is increased.

As described above, a GaN epitaxial substrate suitably used for a GaN-HEMT, which prevents diffusion of Fe to a region where the 2DEG is generated and is also excellent in the degree of freedom in design and manufacturing cost of a device, has not been obtained so far.

As described above, in the related art, precise control of the Fe concentration of the HEMT device has not been implemented.

### SOLUTION TO PROBLEM

In order to achieve the above objects, the present inventors have conducted intensive studies, and have focused on the fact that, as a first aspect, by intentionally inhibiting the movement of Fe in the GaN substrate or the GaN buffer layer, a Fe concentration distribution can be controlled more effectively than simply restricting the thermal diffusion of Fe as in the related art. The present inventors have further conducted studies and found that the above objects can be achieved by making a concentration gradient of Fe extremely steep in a [0001] axis direction from the GaN substrate containing Fe or the GaN buffer layer containing Fe, and have completed the present invention.

In order to achieve the above objects, the present inventors have conducted intensive studies and found that, as a second aspect, the movement of Fe is effectively inhibited and the above objects can be achieved by having a configuration in which the GaN substrate or the GaN buffer layer includes a Fe-doped layer obtained by doping with Fe and the GaN buffer layer includes a C-containing layer having a specific C concentration or a Fe diffusion-restricting layer containing C, and have completed the present invention.

That is, the gist of the first aspect of the present invention is as follows.

According to aspect 1 of the present invention, there is provided a GaN epitaxial substrate including a GaN substrate, and a GaN buffer layer epitaxially grown on the GaN substrate, in which the GaN epitaxial substrate includes a point A and a point B which is positioned on a straight line parallel to a [0001] axis passing through the point A, the point B being present in a [0001] axis direction relative to the point A, the point A is present in the GaN substrate or the GaN buffer layer, the point B is present in the GaN buffer layer, a ratio ([Fe]_{B}/[Fe]_{A}) is 1/100, [Fe]_{A} being a Fe concentration of the point A and [Fe]_{B} being a Fe concentration of the point B, and a distance between the point A and the point B is 0.2 µm or less.

According to aspect 2 of the present invention, there is provided a GaN epitaxial substrate including a GaN substrate, and a GaN buffer layer epitaxially grown on the GaN substrate, in which the GaN epitaxial substrate includes a point A' and a point B' which is positioned on a straight line parallel to a [0001] axis passing through the point A', the point B' is present in a [0001] axis direction relative to the point A', the point A' is present in the GaN substrate or the GaN buffer layer, the point B' is present in the GaN buffer layer, a ratio ([Fe]_{B'}/[Fe]_{A'}) is 1/10, [Fe]_{A'} being a Fe concentration of the point A' and [Fe]_{B'} being a Fe concentration of the point B', and a distance between the point A' and the point B' is 0.1 µm or less.

According to aspect 3 of the present invention, there is provided a GaN epitaxial substrate including a GaN substrate and a GaN buffer layer epitaxially grown on the GaN substrate, in which the GaN epitaxial substrate includes a point A" and a point B" which is positioned on a straight line parallel to a [0001] axis passing through the point A", the point B" is present in a [0001] axis direction relative to the point A", the point A" is present in the GaN substrate or the GaN buffer layer, the point B" is present in the GaN buffer layer, a Fe concentration of the point A" is 1 × 10¹⁷ atoms/cm³ or more, a Fe concentration of the point B" is 1 × 10¹⁵ atoms/cm³ or less, and a distance between the point A" and the point B" is 0.2 µm or less.

According to aspect 4 of the present invention, there is provided a GaN epitaxial substrate including a GaN substrate, and a GaN buffer layer epitaxially grown on the GaN substrate, in which the GaN epitaxial substrate includes a point A‴ and a point B‴ which is positioned on a straight line parallel to a [0001] axis passing through the point A‴, the point B‴ is present in a [0001] axis direction relative to the point A‴, the point A‴ is present in the GaN substrate or the GaN buffer layer, the point B‴ is present in the GaN buffer layer, a Fe concentration of the point A‴ is 1 × 10¹⁷ atoms/cm³ or more, a Fe concentration of the point B‴ is 1 × 10¹⁶ atoms/cm³ or less, and a distance between the point A‴ and the point B‴ is 0.1 µm or less.

According to aspect 5 of the present invention, in the GaN epitaxial substrate according to aspect 1 or 2, the [Fe]_{A} or the [Fe]_{A'} is 1 × 10¹⁷ atoms/cm³ or more.

According to aspect 6 of the present invention, in the GaN epitaxial substrate according to any one of aspects 1 to 5, the point A, the point A', the point A", or the point A‴ is present in the GaN substrate.

According to aspect 7 of the present invention, in the GaN epitaxial substrate according to any one of aspects 1 to 6 , the GaN buffer layer includes a C-containing region having a C concentration of 1 × 10¹⁶ to 1 × 10¹⁸ atoms/cm³, and the C-containing region includes the point B, the point B', the point B", or the point B‴, or is positioned closer to a (000-1) plane than a plane including the point B, the point B', the point B", or the point B‴, the plate being parallel to a (0001) plane.

According to aspect 8 of the present invention, in the GaN epitaxial substrate according to any one of aspects 1 to 7, at least one of the GaN substrate and the GaN buffer layer includes a Fe-doped layer obtained by doping with Fe.

According to aspect 9 of the present invention, in the GaN epitaxial substrate according to any one of aspects 1 to 8, the GaN substrate includes the Fe-doped layer obtained by doping with Fe, and the point A, the point A', the point A", or the point A‴ is present in the Fe-doped layer.

According to aspect 10 of the present invention, in the GaN epitaxial substrate according to any one of aspects 7 to 9, the GaN buffer layer has an i-GaN layer in the [0001] axis direction relative to the C-containing region.

According to aspect 11 of the present invention, the GaN epitaxial substrate according to any one of aspects 1 to 10 further includes a nitride semiconductor barrier layer on the GaN buffer layer.

The gist of the second aspect of the present invention is as follows.

According to aspect 12 of the present invention, there is provided a GaN epitaxial substrate including a GaN substrate, and a GaN buffer layer epitaxially grown on the GaN substrate, in which at least one of the GaN substrate and the GaN buffer layer includes a Fe-doped layer obtained by doping with Fe, the GaN buffer layer includes a C-containing layer, and the C-containing layer is present in a [0001] axis direction relative to the Fe-doped layer, and has a C concentration of 1 × 10¹⁶ to 1 × 10¹⁸ atoms/cm³.

According to aspect 13 of the present invention, there is provided a GaN epitaxial substrate including a GaN substrate, and a GaN buffer layer epitaxially grown on the GaN substrate, in which the GaN substrate or the GaN buffer layer includes a Fe-doped layer obtained by doping with Fe, the GaN buffer layer includes a Fe diffusion-restricting layer configured to restrict diffusion of Fe, the Fe diffusion-restricting layer is present in an [0001] axis direction relative to the Fe-doped layer, and the Fe diffusion-restricting layer contains C.

According to aspect 14 of the present invention, in the GaN epitaxial substrate according to aspect 13, the Fe diffusion-restricting layer has a C concentration of 1 × 10¹⁸ atoms/cm³ or less.

According to aspect 15 of the present invention, in the GaN epitaxial substrate according to any one of aspects 12 to 14, the GaN substrate includes the Fe-doped layer.

According to aspect 16 of the present invention, in the GaN epitaxial substrate according to any one of aspects 12 to 15, the Fe-doped layer has a Fe concentration of 1 × 10¹⁷ atoms/cm³ or more.

According to aspect 17 of the present invention, in the GaN epitaxial substrate according to any one of aspects 12 to 16, the C-containing layer or the Fe diffusion-restricting layer is a layer doped with C.

According to aspect 18 of the present invention, in the GaN epitaxial substrate according to any one of aspects 12 to 17, a GaN region positioned in the C-containing layer or the Fe diffusion-restricting layer or in the [0001] axis direction relative to the C-containing layer or the Fe diffusion-restricting layer in the GaN buffer layer has a Fe concentration of less than 1 × 10¹⁷ atoms/cm³.

According to aspect 19 of the present invention, in the GaN epitaxial substrate according to any one of aspects 12 to 18, the GaN substrate or the GaN buffer layer includes a point A, the GaN buffer layer includes a point B positioned on a straight line parallel to a [0001] axis passing through the point A, the point B being present in the [0001] axis direction relative to the point A, a ratio ([Fe]_{B}/[Fe]_{A}) is 1/100, [Fe]_{A} being a Fe concentration of the point A, and [Fe]_{B} being a Fe concentration of the point B, and a distance between the point A and the point B is 0.2 µm or less.

According to aspect 20 of the present invention, in the GaN epitaxial substrate according to any one of aspects 12, 15 to 19, the GaN buffer layer has an i-GaN layer in the [0001] axis direction relative to the C-containing region.

According to aspect 21 of the present invention, the GaN epitaxial substrate according to any one of aspects 12 to 20 further includes a nitride semiconductor barrier layer on the GaN buffer layer.

### ADVANTAGEOUS EFFECTS OF INVENTION

In the GaN epitaxial substrate according to the present embodiment, diffusion of Fe into a region other than the GaN substrate or the GaN buffer layer intended to have high resistance is restricted, and the degree of freedom in design and manufacturing cost of the device are also good. Therefore, the GaN epitaxial substrate is very suitable as a substrate used for a nitride semiconductor device having a lateral device structure such as a GaN-HEMT.

### BRIEF DESCRIPTION OF DRAWINGS

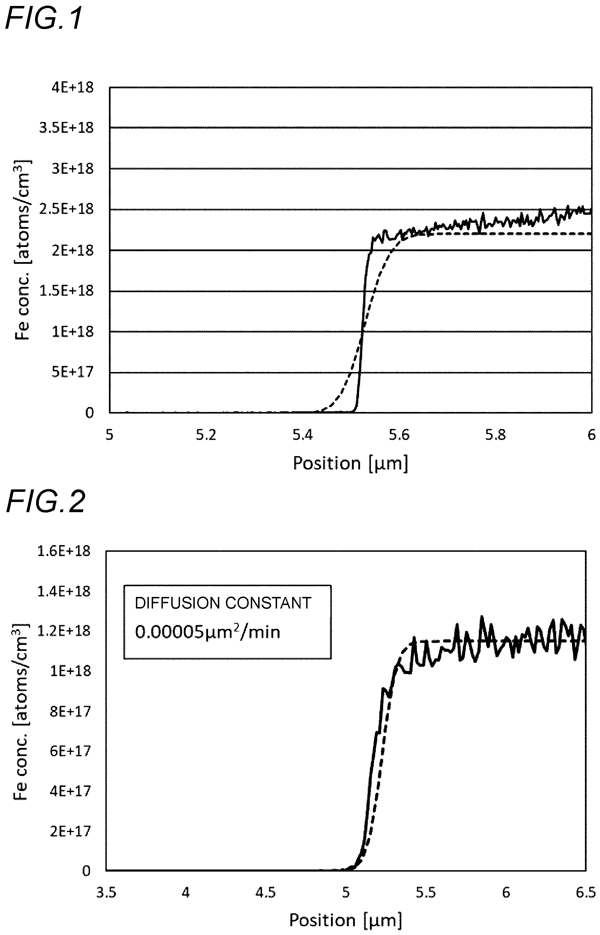

[FIG. 1] FIG. 1 shows a Fe concentration profile at an interface between a Fe-doped layer and a C-containing region in a GaN epitaxial substrate, in which a solid line is based on an actual measurement result of an SIMS measurement according to Example 1, and a broken line is based on a calculation result of a diffusion equation, which corresponds to a result according to Comparative Example 2 without the C-containing region.
[FIG. 2] FIG. 2 shows a Fe concentration profile at an interface between a Fe-doped layer and an undoped GaN buffer layer in a GaN epitaxial substrate according to Comparative Example 1, in which a solid line is based on an actual measurement result of an SIMS measurement according to Comparative Example 1, and a broken line is based on fitting results using the diffusion equation to the above actual measurement results.

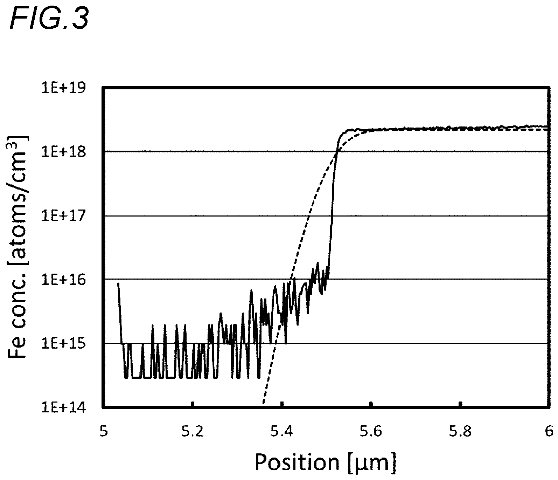

[FIG. 3] FIG. 3 is a Fe concentration profile in which the Fe concentration, which is represented by a vertical axis in FIG. 1, is expressed in logarithm, and similarly to FIG. 1, a solid line is based on an actual measurement result of an SIMS measurement according to Example 1, and a broken line is based on a calculation result of a diffusion equation, which corresponds to a result according to Comparative Example 2 without the C-containing region.

### DESCRIPTION OF EMBODIMENTS

Hereinafter, embodiments of the present invention are specifically described, but the present invention is not limited to the following embodiments, and the present invention can be implemented with various modifications within the scope of a gist thereof.

In the present description, a crystal axis parallel to a [0001] axis is called a c-axis, a crystal axis parallel to a <10-10> axis is called an m-axis, and a crystal axis parallel to a <11-20> axis is called an a-axis. A crystal plane perpendicular to the c-axis is called a c-plane, a crystal plane perpendicular to the m-axis is called an m-plane, and a crystal plane perpendicular to the a-axis is called an a-plane.

The Miller index (h k i l) of a hexagonal crystal has a relationship of h + k = -i, and therefore, it may also be represented by three digits of (h k l). For example, when (0 0 0 4) is expressed in three digits, it is (0 0 4).

In the present description, when referring to a crystal axis, a crystal plane, a crystal orientation, and the like, they mean a crystal axis, a crystal plane, a crystal orientation, and the like in a GaN epitaxial substrate, that is, a GaN substrate or a GaN buffer layer, unless otherwise specified.

In the present description, the Fe concentration and the C concentration of a specific position are values determined by respective detection amounts using secondary ion mass spectrometry (SIMS).

In the present description, the expression "to" is used as an expression including numerical values or physical property values before and after the expression. That is, "A to B" means A or more and B or less.

In the HEMT structure, a crystal layer made of GaN and epitaxially grown on a substrate is generally referred to as a GaN buffer layer. Accordingly, in the present description, the crystal layer made of GaN and epitaxially grown on the GaN substrate is referred to as a "GaN buffer layer".

### <<First Aspect>>

### [GaN Epitaxial Substrate]

A GaN epitaxial substrate according to a first embodiment in the first aspect includes a GaN substrate and a GaN buffer layer epitaxially grown on the GaN substrate. The GaN epitaxial substrate includes a point A and a point B positioned on a straight line parallel to a [0001] axis passing through the point A, and the point B is present in a [0001] axis direction relative to the point A. The point A is present in the GaN substrate or the GaN buffer layer, and the point B is present in the GaN buffer layer. A ratio ([Fe]_{B}/[Fe]_{A}) of a Fe concentration of the point B [Fe]_{B} to a Fe concentration of the point A [Fe]_{A} is 1/100, and a distance between the point A and the point B is 0.2 µm or less.

The expression "point B is present in the [0001] axis direction relative to the point A" means that the point B is present in a +c-axis direction relative to the point A, that is, in a Ga polar plane direction of a crystal. The same applies to a relationship between a point A' and a point B' according to a second embodiment in the first aspect described below, a relationship between a point A" and a point B" according to a third embodiment in the first aspect, and a relationship between a point A‴ and a point B‴ according to a fourth embodiment in the first aspect.

The expression "the GaN epitaxial substrate includes the point A and the point B" means that at least one pair of the point A and the point B that satisfy the aforementioned relationship are present in the GaN epitaxial substrate. That is, the GaN epitaxial substrate according to the first embodiment in the first aspect may have at least one pair of the point A and the point B that satisfy the aforementioned relationship. In the GaN epitaxial substrate, it is preferable that three or more pairs of the point A and point B satisfying the aforementioned relationship are present on the same plane parallel to the (0001) plane, and each pair is positioned apart from each other by 1 mm or more. The same applies to a relationship between a point A' and a point B' according to a second embodiment in the first aspect described below, a relationship between a point A" and a point B" according to a third embodiment in the first aspect, and a relationship between a point A‴ and a point B‴ according to a fourth embodiment in the first aspect.

The description that the distance between the point A and the point B at which [Fe]_{B}/[Fe]_{A} is 1/100 is 0.2 µm or less means that a concentration gradient of Fe between the two points, the point A and the point B, is steep, and the diffusion of Fe is suitably inhibited. Accordingly, the diffusion of Fe to a region where a 2DEG is generated can be prevented in a GaN-HEMT structure while ensuring a semi-insulating property of Fe.

The Fe concentration of the point A [Fe]_{A} is preferably 1 × 10¹⁷ atoms/cm³ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³, from the viewpoint of ensuring sufficient semi-insulating properties. Here, the [Fe]a is preferably 1 × 10¹⁷ atoms/cm³ or more, more preferably 5 × 10¹⁷ atoms/cm³ or more, and still more preferably 1 × 10¹⁸ atoms/cm³ or more. From the viewpoint of maintaining good crystal quality, [Fe]_{A} is preferably 1 × 10²⁰ atoms/cm³ or less, more preferably 1 × 10¹⁹ atoms/cm³ or less, and still more preferably 5 × 10¹¹ atoms/cm³ or less.

The Fe concentration of the point B [Fe]_{B} is 1/100 of the Fe concentration of the point A [Fe]_{A}, and therefore, a preferable range of [Fe]_{B} may change depending on [Fe]_{A}.

The distance between the point A and the point B may be 0.2 µm or less, and is preferably 0.15 µm or less, more preferably 0.13 µm or less, and still more preferably 0.12 µm or less from the viewpoint of making the concentration gradient of Fe steeper. The distance between the point A and the point B is preferably as short as possible, and is generally 0.01 µm or more from the viewpoint of achievability.

The point A may be present in the GaN substrate or the GaN buffer layer, and is preferably present in the GaN substrate from the viewpoint of ease of production.

On the other hand, the point B is present in the GaN buffer layer.

The ease of the above production will be described. In the case where the point A is present in the GaN buffer layer, both the point A and the point B are included in the GaN buffer layer epitaxially grown by a MOCVD method or the like. In the case where the doping with Fe is adopted as a method for achieving the Fe concentration of the point A, a Fe dopant gas used may remain in a reaction tube, and Fe may be unintentionally incorporated when a region where the point B is originally present is formed. When such unintended incorporation of Fe occurs, it is difficult to set the point B having a Fe concentration of 1/100 of the Fe concentration of the point A [Fe]_{A} in a range of 0.2 µm or less from the point A, and further steps are required to control the concentration gradient of Fe. In contrast, when the point A is present in the GaN substrate, the unintended incorporation of Fe can be prevented, so that the point B can be easily set in a range of 0.2 µm or less from the point A. As a result, the GaN epitaxial substrate according to the present embodiment in the first aspect can be easily produced.

However, as a result of the high Fe concentration of the GaN substrate and the thermal diffusion of Fe into the GaN buffer layer, the point A and the point B may be present in the GaN buffer layer without performing doping with Fe. In this case, it is not necessary to consider that Fe is unintentionally incorporated when the region where the point B is originally present is formed.

At least one of the GaN substrate and the GaN buffer layer preferably includes a Fe-doped layer obtained by doping with Fe, and the GaN substrate more preferably includes a Fe-doped layer from the viewpoint of ease of production. The point A is more preferably present in the Fe-doped layer in the GaN substrate. However, the presence of the point A in the GaN buffer layer is not excluded due to the thermal diffusion of Fe from the Fe-doped layer in the GaN substrate.

In the present specification, the Fe-doped layer obtained by doping with Fe means a region where the Fe concentration is 1 × 10¹⁷ atoms/cm³ or more, and can be distinguished from a case where Fe is unintentionally introduced in the process of producing the GaN epitaxial substrate.

In the case where the GaN substrate includes the Fe-doped layer, an upper end surface of the Fe-doped layer is preferably present at a position coincident with the (0001) surface of the GaN substrate. A thickness of the Fe-doped layer in a c-axis direction is not required to coincide with the thickness of the GaN substrate in the c-axis direction. For example, a thickness of the entire GaN substrate is 400 µm, whereas a thickness of the Fe-doped layer is sufficient if it is included in the top 100 µm of the GaN substrate. Of course, the thickness of the Fe-doped layer is not limited to the above, and the case where the Fe-doped layer has a thickness larger or smaller than the above thickness is not excluded at all. In addition, a GaN substrate in which the entire GaN substrate in the thickness direction is formed by the Fe-doped layer may be used.

In the case where the GaN substrate includes the Fe-doped layer, the thickness of the Fe-doped layer may be 50 µm to 500 µm. In the case where the GaN substrate includes the Fe-doped layer, the thickness of the Fe-doped layer may be 50 µm or more, 80 µm or more, or 100 µm or more. On the other hand, the thickness of the Fe-doped layer may be 500 µm or less.

In the case where the GaN substrate includes the Fe-doped layer, the C concentration of the Fe-doped layer is preferably 5 × 10¹⁶ atoms/cm³ or less. In the case where the GaN substrate includes the Fe-doped layer, the C concentration of the Fe-doped layer may be 4 × 10¹⁶ atoms/cm³ or less, 3 × 10¹⁶ atoms/cm³ or less, or 2 × 10¹⁶ atoms/cm³ or less.

The GaN buffer layer preferably includes a C-containing region having a C concentration of 1 × 10¹⁶ to 1 × 10¹⁸ atoms/cm³. The presence of the C-containing region inhibits Fe from moving between different regions defined by the C-containing region.

The movement of Fe in the GaN epitaxial substrate is generally caused by thermal diffusion defined by the diffusion equation. Therefore, a concentration distribution of Fe in the GaN epitaxial substrate is originally described by the diffusion equation. However, in the case where the C-containing region is present, it has been found that a concentration distribution of Fe around the C-containing region deviates from a behavior predicted by the diffusion equation and shows a steep Fe concentration gradient. Therefore, it is considered that the presence of the C-containing region effectively inhibits the movement of Fe in the GaN epitaxial substrate.

The C concentration of the C-containing region is preferably 1 × 10¹⁶ atoms/cm³ or more and 1 × 10¹⁸ atoms/cm³ or less, more preferably 5 × 10¹⁶ atoms/cm³ or more and 1 × 10¹⁸ atoms/cm³ or less, still more preferably 1 × 10¹⁷ atoms/cm³ or more and 8 × 10¹⁷ atoms/cm³ or less, and particularly preferably 1 × 10¹⁷ atoms/cm³ or more and 5 × 10¹⁷ atoms/cm³ or less. Here, the above C concentration of the C-containing region is preferably 1 × 10¹⁶ atoms/cm³ or more, more preferably 5 × 10¹⁶ atoms/cm³ or more, and still more preferably 1 × 10¹⁷ atoms/cm³ or more, from the viewpoint of further inhibiting the movement of Fe. The C concentration in the C-containing region is preferably 1 × 10¹⁸ atoms/cm³ or less, more preferably less than 1 × 10¹¹ atoms/cm³, still more preferably 8 × 10¹⁷ atoms/cm³ or less, and particularly preferably 5 × 10¹⁷ atoms/cm³ or less, from the viewpoint of preventing the occurrence of defects such as threading dislocations and from the viewpoint of preventing the leakage current caused by C.

It is preferable that the C-containing region includes the point B, or is positioned closer to a (000-1) plane than a plane including the point B and parallel to the (0001) plane. That is, it is preferable that the point B is present in the C-containing region or the C-containing region is present between a plane including the point A and parallel to the (0001) plane and a plane including the point B and parallel to the (0001) plane.

The thickness of the C-containing region in the c-axis direction is preferably 50 nm to 900 nm, more preferably 100 nm to 600 nm, and still more preferably 200 nm to 500 nm. Here, from the viewpoint of normal device fabrication, the above thickness of the C-containing region is preferably 50 nm or more, more preferably 100 nm or more, and still more preferably 200 nm or more. From the viewpoint of reducing the leakage current, the above thickness of the C-containing region is preferably 900 nm or less, more preferably 600 nm or less, and still more preferably 500 nm or less.

The thickness of the C-containing region in the c-axis direction is preferably 5% to 90%, more preferably 10% to 80%, and still more preferably 20% to 70% of the total film thickness of the GaN buffer layer. Here, from the viewpoint of normal device fabrication, the above thickness is preferably 5% or more, more preferably 10% or more, and still more preferably 20% or more of a total thickness of the GaN buffer layer. From the same viewpoint, the above thickness is preferably 90% or less, more preferably 80% or less, and still more preferably 70% or less of a total film thickness of the GaN buffer layer. In the case where the GaN buffer layer includes a Fe-doped layer, a C-containing region, an i-GaN layer, and the like as described below, the total thickness of the GaN buffer layer refers to a total thickness, in the c-axis direction, including the Fe-doped layer, the C-containing region, the i-GaN layer, and the like.

A GaN epitaxial substrate according to a second embodiment in the first aspect includes a GaN substrate and a GaN buffer layer epitaxially grown on the GaN substrate. The GaN epitaxial substrate includes the point A', and the point B' positioned on a straight line parallel to the [0001] axis passing through the point A', and the point B' is present in the [0001] axis direction relative to the point A'. The point A' is present in the GaN substrate or the GaN buffer layer, and the point B' is present in the GaN buffer layer. A ratio ([Fe]_{B'}/[Fe]_{A'}) of a Fe concentration of the point B' [Fe]_{B'} to a Fe concentration of the point A' [Fe]_{A'} is 1/10, and a distance between the point A' and the point B' is 0.1 µm or less.

The description that the distance between the point A' and the point B' at which [Fe]_{B'}/[Fe]_{A'} is 1/10 is 0.1 µm or less means that a concentration gradient of Fe between the two points, the point A' and the point B', is steep, and the diffusion of Fe is suitably inhibited. Accordingly, the diffusion of Fe to a region where a 2DEG is generated can be prevented in a GaN-HEMT structure while ensuring a semi-insulating property of Fe.

The Fe concentration of the point A' [Fe]_{A'} is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, from the viewpoint of ensuring sufficient semi-insulating properties, the above [Fe]_{A'} is preferably 1 × 10¹⁷ atoms/cm³ or more, more preferably 5 × 10¹⁷ atoms/cm³ or more, and still more preferably 1 × 10¹⁸ atoms/cm³ or more. In addition, from the viewpoint of maintaining good crystal quality, the above [Fe]_{A'} is preferably 1 × 10²⁰ atoms/cm³ or less, more preferably 1 × 10¹⁹ atoms/cm³ or less, and still more preferably 5 × 10¹⁸ atoms/cm³ or less.

The Fe concentration of the point B' [Fe]_{B'} is 1/10 of the Fe concentration of the point A' [Fe]_{A'}, and therefore, a preferable range of [Fe]_{B'} may change depending on [Fe]_{A'}.

The distance between the point A' and the point B' may be 0.1 µm or less, and the distance is preferably 0.08 µm or less, and more preferably 0.05 µm or less from the viewpoint of making the concentration gradient of Fe steeper. The distance between the point A' and the point B' is preferably as short as possible, and is generally 0.01 µm or more from the viewpoint of achievability.

The point A' may be present in the GaN substrate or the GaN buffer layer, and is preferably present in the GaN substrate from the viewpoint of ease of production. The ease of the above production is the same as the point A according to the first embodiment in the first aspect.

On the other hand, the point B' is present in the GaN buffer layer.

At least one of the GaN substrate and the GaN buffer layer preferably includes a Fe-doped layer obtained by doping with Fe, and the GaN substrate more preferably includes a Fe-doped layer from the viewpoint of ease of production. The point A' is more preferably present in the Fe-doped layer in the GaN substrate. However, the presence of the point A' in the GaN buffer layer is not excluded due to the thermal diffusion of Fe from the Fe-doped layer in the GaN substrate.

In the case where the GaN substrate includes the Fe-doped layer, an upper end surface of the Fe-doped layer is preferably present at a position coincident with the (0001) surface of the GaN substrate. A thickness of the Fe-doped layer in a c-axis direction is not required to coincide with the thickness of the GaN substrate in the c-axis direction. For example, a thickness of the entire GaN substrate is 400 µm, whereas a thickness of the Fe-doped layer is sufficient if it is included in the top 100 µm of the GaN substrate. Of course, the thickness of the Fe-doped layer is not limited to the above, and the case where the Fe-doped layer has a thickness larger or smaller than the above thickness is not excluded at all. In addition, a substrate in which the entire GaN substrate in the thickness direction is formed by the Fe-doped layer may be used.

In the case where the GaN substrate includes the Fe-doped layer, the thickness of the Fe-doped layer may be 50 µm to 500 µm. In the case where the GaN substrate includes the Fe-doped layer, the thickness of the Fe-doped layer may be 50 µm or more, 80 µm or more, or 100 µm or more. On the other hand, the thickness of the Fe-doped layer may be 500 µm or less.

In the case where the GaN substrate includes the Fe-doped layer, the C concentration of the Fe-doped layer is preferably 5 × 10¹⁶ atoms/cm³ or less. In the case where the GaN substrate includes the Fe-doped layer, the C concentration of the Fe-doped layer may be 4 × 10¹⁶ atoms/cm³ or less, 3 × 10¹⁶ atoms/cm³ or less, 2 × 10¹⁶ atoms/cm³ or less, or less than 1 × 10¹⁶ atoms/cm³.

The GaN buffer layer preferably includes a C-containing region having a C concentration of 1 × 10¹⁶ to 1 × 10¹⁸ atoms/cm³. The presence of the C-containing region inhibits Fe from moving between different regions defined by the C-containing region.

It is preferable that the C-containing region includes the point B', or is positioned closer to the (000-1) plane than a plane including the point B' and parallel to the (0001) plane. That is, it is preferable that the point B' is present in the C-containing region or the C-containing region is present between a plane including the point A' and parallel to the (0001) plane and a plane including the point B' and parallel to the (0001) plane.

The preferable C concentration and thickness of the C-containing region are the same as the preferable C concentration and thickness of the C-containing region according to the first embodiment in the first aspect.

A GaN epitaxial substrate according to a third embodiment in the first aspect includes a GaN substrate and a GaN buffer layer epitaxially grown on the GaN substrate. The GaN epitaxial substrate includes the point A", and the point B" positioned on a straight line parallel to the [0001] axis passing through the point A", and the point B" is present in the [0001] axis direction relative to the point A". The point A" is present in the GaN substrate or the GaN buffer layer, and the point B" is present in the GaN buffer layer. A Fe concentration of the point A" is 1 × 10¹⁷ atoms/cm³ or more, a Fe concentration of the point B" is 1 × 10¹⁵ atoms/cm³ or less, and the distance between the point A" and the point B" is 0.2 µm or less.

The Fe concentration of the point A" is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, from the viewpoint of ensuring sufficient semi-insulating properties, the Fe concentration of the point A" is 1 × 10¹⁷ atoms/cm³ or more, preferably 5 × 10¹⁷ atoms/cm³ or more, and more preferably 1 × 10¹⁸ atoms/cm³ or more. In addition, from the viewpoint of maintaining good crystal quality, the Fe concentration of the point A" is preferably 1 × 10²⁰ atoms/cm³ or less, more preferably 1 × 10¹⁹ atoms/cm³ or less, and still more preferably 5 × 10¹⁸ atoms/cm³ or less.

When the Fe concentration of the point B" is 1 × 10¹⁵ atoms/cm³ or less, it can be said that the concentration gradient of Fe is steep in relation to the point A", and the diffusion of Fe is suitably inhibited. That is, diffusion of Fe to the region where a 2DEG is generated can be restricted in the GaN-HEMT structure. The Fe concentration of the point B" is preferably less than 1 × 10¹⁵ atoms/cm³, more preferably less than 8 × 10¹⁴ atoms/cm³, and still more preferably less than 5 × 10¹⁴ atoms/cm³. A lower limit of the Fe concentration of the point B" is not particularly limited, and the detection limit of Fe generally coincides with the lower limit.

A ratio ([Fe]_{B"}/[Fe]_{A"}) of a Fe concentration of the point B" [Fe]_{B"} to a Fe concentration of the point A" [Fe]_{A"} is 1/100 or less, and from the viewpoint that the concentration gradient of Fe is steep and diffusion of Fe is more suitably inhibited, [Fe ]_{B"}/[Fe]_{A"} is preferably 1/500 or less, and more preferably 1/1000 or less. The lower limit of [Fe]_{B"}/[Fe]_{A"} is not particularly limited, and is about 1/3000 that can be actually achieved.

The distance between the point A" and the point B" may be 0.2 µm or less, and is preferably 0.15 µm or less, more preferably 0.13 µm or less, and still more preferably 0.12 µm or less from the viewpoint of making the concentration gradient of Fe steeper. The distance between the point A" and the point B" is preferably as short as possible, and is generally 0.01 µm or more from the viewpoint of achievability.

The point A" may be present in the GaN substrate or the GaN buffer layer, and is preferably present in the GaN substrate from the viewpoint of ease of production. The ease of the above production is the same as the point A according to the first embodiment in the first aspect.

On the other hand, the point B" is present in the GaN buffer layer.

At least one of the GaN substrate and the GaN buffer layer preferably includes a Fe-doped layer obtained by doping with Fe, and the GaN substrate more preferably includes a Fe-doped layer from the viewpoint of ease of production. The point A" is more preferably present in the Fe-doped layer. However, the presence of the point A" in the GaN buffer layer is not excluded due to the thermal diffusion of Fe from the Fe-doped layer in the GaN substrate.

In the case where the GaN substrate includes the Fe-doped layer, an upper end surface of the Fe-doped layer is preferably present at a position coincident with the (0001) surface of the GaN substrate. A thickness of the Fe-doped layer in a c-axis direction is not required to coincide with the thickness of the GaN substrate in the c-axis direction. For example, a thickness of the entire GaN substrate is 400 µm, whereas a thickness of the Fe-doped layer is sufficient if it is included in the top 100 µm of the GaN substrate. Of course, the thickness of the Fe-doped layer is not limited to the above, and the case where the Fe-doped layer has a thickness larger or smaller than the above thickness is not excluded at all. In addition, a substrate in which the entire GaN substrate in the thickness direction is formed by the Fe-doped layer may be used.

In the case where the GaN substrate includes the Fe-doped layer, the thickness of the Fe-doped layer may be 50 µm to 500 µm. In the case where the GaN substrate includes the Fe-doped layer, the thickness of the Fe-doped layer may be 50 µm or more, 80 µm or more, or 100 µm or more. On the other hand, the thickness of the Fe-doped layer may be 500 µm or less.

In the case where the GaN substrate includes the Fe-doped layer, the C concentration of the Fe-doped layer is preferably 5 × 10¹⁶ atoms/cm³ or less. In the case where the GaN substrate includes the Fe-doped layer, the C concentration of the Fe-doped layer may be 4 × 10¹⁶ atoms/cm³ or less, 3 × 10¹⁶ atoms/cm³ or less, 2 × 10¹⁶ atoms/cm³ or less, or less than 1 × 10¹⁶ atoms/cm³.

The GaN buffer layer preferably includes a C-containing region having a C concentration of 1 × 10¹⁶ to 1 × 10¹⁸ atoms/cm³. The presence of the C-containing region inhibits Fe from moving between different regions defined by the C-containing region.

It is preferable that the C-containing region includes the point B", or is positioned closer to the (000-1) plane than a plane including the point B" and parallel to the (0001) plane. That is, it is preferable that the point B" is present in the C-containing region or the C-containing region is present between a plane including the point A" and parallel to the (0001) plane and a plane including the point B" and parallel to the (0001) plane.

The preferable C concentration and thickness of the C-containing region are the same as the preferable C concentration and thickness of the C-containing region according to the first embodiment in the first aspect.

A GaN epitaxial substrate according to a fourth embodiment in the first aspect includes a GaN substrate and a GaN buffer layer epitaxially grown on the GaN substrate. The GaN epitaxial substrate includes a point A‴ and a point B‴ positioned on a straight line parallel to the [0001] axis passing through the point A‴, and the point B‴ is present in the [0001] axis direction relative to the point A"'. The point A‴ is present in the GaN substrate or the GaN buffer layer, and the point B‴ is present in the GaN buffer layer. A Fe concentration of the point A‴ is 1 × 10¹⁷ atoms/cm³ or more, a Fe concentration of the point B‴ is 1 × 10¹⁶ atoms/cm³ or less, and the distance between the point A‴ and the point B‴ is 0.1 µm or less.

The Fe concentration of the point A‴ is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, from the viewpoint of ensuring sufficient semi-insulating properties, the Fe concentration of the point A‴ is 1 × 10¹⁷ atoms/cm³ or more, preferably 5 × 10¹⁷ atoms/cm³ or more, and more preferably 1 × 10¹⁸ atoms/cm³ or more. In addition, from the viewpoint of maintaining good crystal quality, the Fe concentration of the point A‴ is preferably 1 × 10²⁰ atoms/cm³ or less, more preferably 1 × 10¹⁹ atoms/cm³ or less, and still more preferably 5 × 10¹¹ atoms/cm³ or less.

When the Fe concentration of the point B‴ is 1 × 10¹⁶ atoms/cm³ or less, it can be said that the concentration gradient of Fe is steep in relation to the point A‴, and the diffusion of Fe is suitably inhibited. That is, diffusion of Fe to the region where a 2DEG is generated can be restricted in the GaN-HEMT structure. The Fe concentration of the point B‴ is preferably 5 × 10¹⁵ atoms / cm³ or less, and more preferably 1 × 10¹⁵ atoms / cm³ or less. A lower limit of the Fe concentration of the point B‴ is not particularly limited, and the detection limit of Fe generally coincides with the lower limit.

A ratio ([Fe]_{B‴}/[Fe]_{A‴}) of a Fe concentration of the point B‴ [Fe]_{B‴} to a Fe concentration of the point A‴ |Fe|_{A‴} is 1/10 or less, and from the viewpoint that the concentration gradient of Fe is steep and diffusion of Fe is more suitably inhibited, [Fe]_{B‴}//[Fe]_{A‴} is preferably 1/100 or less, and more preferably 1/500 or less. The lower limit of [Fe]_{B‴}/[Fe]_{A‴} is not particularly limited, and is about 1/3000 that can be actually achieved.

The distance between the point A‴ and the point B‴ may be 0.1 µm or less, and the distance is preferably 0.08 µm or less, and more preferably 0.05 µm or less from the viewpoint of making the concentration gradient of Fe steeper. The distance between the point A‴ and the point B‴ is preferably as short as possible, and is generally 0.01 µm or more from the viewpoint of achievability.

The point A‴ may be present in the GaN substrate or the GaN buffer layer, and is preferably present in the GaN substrate from the viewpoint of ease of production. The ease of the above production is the same as the point A according to the first embodiment in the first aspect.

On the other hand, the point B‴ is present in the GaN buffer layer.

At least one of the GaN substrate and the GaN buffer layer preferably includes a Fe-doped layer obtained by doping with Fe, and the GaN substrate more preferably includes a Fe-doped layer from the viewpoint of ease of production. The point A‴ is more preferably present in the Fe-doped layer in the GaN substrate. However, the presence of the point A‴ in the GaN buffer layer is not excluded due to the thermal diffusion of Fe from the Fe-doped layer in the GaN substrate.

In the case where the GaN substrate includes the Fe-doped layer, an upper end surface of the Fe-doped layer is preferably present at a position coincident with the (0001) surface of the GaN substrate. A thickness of the Fe-doped layer in a c-axis direction is not required to coincide with the thickness of the GaN substrate in the c-axis direction. For example, a thickness of the entire GaN substrate is 400 µm, whereas a thickness of the Fe-doped layer is sufficient if it is included in the top 100 µm of the GaN substrate. Of course, the thickness of the Fe-doped layer is not limited to the above, and the case where the Fe-doped layer has a thickness larger or smaller than the above thickness is not excluded at all. In addition, a GaN substrate in which the entire GaN substrate in the thickness direction is formed by the Fe-doped layer may be used.

In the case where the GaN substrate includes the Fe-doped layer, the thickness of the Fe-doped layer may be 50 µm to 500 µm. In the case where the GaN substrate includes the Fe-doped layer, the thickness of the Fe-doped layer may be 50 µm or more, 80 µm or more, or 100 µm or more. On the other hand, the thickness of the Fe-doped layer may be 500 µm or less.

In the case where the GaN substrate includes the Fe-doped layer, the C concentration of the Fe-doped layer is preferably 5 × 10¹⁶ atoms/cm³ or less. In the case where the GaN substrate includes the Fe-doped layer, the C concentration of the Fe-doped layer may be 4 × 10¹⁶ atoms/cm³ or less, 3 × 10¹⁶ atoms/cm³ or less, 2 × 10¹⁶ atoms/cm³ or less, or less than 1 × 10¹⁶ atoms/cm³.

The GaN buffer layer preferably includes a C-containing region having a C concentration of 1 × 10¹⁶ to 1 × 10¹⁸ atoms/cm³. The presence of the C-containing region inhibits Fe from moving between different regions defined by the C-containing region.

It is preferable that the C-containing region includes the point B‴, or is positioned closer to the (000-1) plane than a plane including the point B‴ and parallel to the (0001) plane. That is, it is preferable that the point B‴ is present in the C-containing region or the C-containing region is present between a plane including the point A‴ and parallel to the (0001) plane and a plane including the point B‴ and parallel to the (0001) plane.

The preferable C concentration and thickness of the C-containing region are the same as the preferable C concentration and thickness of the C-containing region according to the first embodiment in the first aspect.

In any embodiment of the first embodiment to fourth embodiment (hereinafter, may be referred to as "the present embodiment") in the first aspect, the GaN epitaxial substrate also includes a GaN buffer layer epitaxially grown on the GaN substrate.

In the present embodiment of the first aspect, a GaN substrate is used instead of a SiC substrate or the like which has been widely used in the past. Accordingly, a defect is less likely to occur at an interface with a GaN buffer layer to be subsequently formed, and a high-concentration carrier compensation layer for preventing a leakage current is unnecessary, so that a drain leakage current when a transistor operation of the GaN-HEMT is performed can be prevented.

A total donor impurity concentration of the GaN substrate according to the present embodiment in the first aspect is preferably less than 4.0 × 10¹⁶ atoms/cm³, and more preferably less than 2.0 × 10¹⁶ atoms/cm³ in order to reduce the doping concentration of the compensation impurities.

The total donor impurity concentration is the sum of concentrations of donor impurities contained in the GaN substrate according to the present embodiment in the first aspect. As impurities acting as donors for GaN, O (oxygen), Si (silicon), S (sulfur), Ge (germanium), Sn (tin), and the like are known. The total donor impurity concentration is determined by SIMS.

In two large-area surfaces of the GaN substrate, that is, a pair of main surfaces thereof, the (0001) plane is used as a front surface for epitaxial growth of a nitride semiconductor layer including the GaN buffer layer. The (0001) plane of the GaN substrate is mirror-finished, and the root mean square (RMS) roughness measured with an atomic force microscope (AFM) is generally less than 2 nm, preferably less than 1 nm, and more preferably less than 0.5 nm in a measurement range of 2 µm × 2 µm.

The (000-1) plane of the GaN substrate is a back surface, and therefore, the plane may be mirror-finished or rough-finished.

### •i-GaN Layer

In the present embodiment of the first aspect, in the case where the GaN buffer layer includes the C-containing region, the GaN buffer layer preferably has an i-GaN layer in the [0001] axis direction relative to the C-containing region. The i-GaN layer is more preferably disposed directly on the C-containing region.

The expression "has an i-GaN layer in the [0001] axis direction relative to the C-containing region" means that the i-GaN layer is present in the +c-axis direction relative to the C-containing region, that is, in the Ga polar plane direction of the crystal. The i-GaN layer is a crystal layer made of GaN epitaxially grown without intentionally performing doping with impurities, and is distinguished from the C-containing region by the C concentration. That is, the C concentration of the i-GaN layer is less than 1 × 10¹⁶ atoms/cm³. In the case where the GaN epitaxial substrate according to the present embodiment in the first aspect is used for the HEMT, the i-GaN layer functions as a so-called channel layer.

A thickness of the GaN buffer layer in the c-axis direction is ideally as thin as possible to reduce the drain leakage current during the HEMT operation. The thickness in the c-axis direction of the i-GaN layer in the GaN buffer layer is preferably 50 nm to 900 nm, more preferably 100 nm to 600 nm, and still more preferably 200 nm to 500 nm. Here, from the viewpoint of normal device fabrication, the thickness of the i-GaN layer is preferably 50 nm or more, more preferably 100 nm or more, and still more preferably 200 nm or more. From the viewpoint of reducing the leakage current, the thickness of the i-GaN layer is preferably 900 nm or less, more preferably 600 nm or less, and still more preferably 500 nm or less.

An upper end surface of the i-GaN layer in the GaN buffer layer preferably coincides with the upper end surface of the GaN buffer layer.

### •Nitride Semiconductor Barrier Layer

The GaN epitaxial substrate according to the present embodiment in the first aspect preferably further has a nitride semiconductor barrier layer on the GaN buffer layer, and it is more preferable that the GaN buffer layer has the i-GaN layer and further has a nitride semiconductor barrier layer on the i-GaN layer. A preferred example of the nitride semiconductor barrier layer is an AlₓGa₁₋ₓN (0 < x < 1) layer, and may be an AlInGaN layer. A 2DEG is generated in a region sandwiched between the i-GaN layer and the nitride semiconductor barrier layer.

As a typical example, in a heterostructure of AlₓGa₁₋ₓN (0 < x < 1)/GaN formed on a GaN substrate having a (0001) plane as a main surface, a 2DEG is generated at a hetero interface due to spontaneous polarization and piezoelectric polarization, and a sheet carrier concentration of about 1×10¹³ cm⁻² or more can be obtained without doping with any substance, so that a radio frequency operation is implemented. Therefore, in the case where the GaN epitaxial substrate according to the present embodiment in the first aspect is used for the HEMT, it is essential to include the nitride semiconductor barrier layer.

The thickness of the nitride semiconductor barrier layer in the c-axis direction is preferably 1 nm to 50 nm, more preferably 5 nm to 40 nm, and still more preferably 10 nm to 30 nm. Here, the above thickness of the nitride semiconductor barrier layer is preferably 1 nm or more, more preferably 5 nm or more, and still more preferably 10 nm or more from the viewpoint of normal device fabrication. From the viewpoint of reducing the leakage current, the above thickness of the nitride semiconductor barrier layer is preferably 50 nm or less, more preferably 40 nm or less, and still more preferably 30 nm or less.

### •GaN Cap Layer

In the case where the GaN epitaxial substrate according to the present embodiment in the first aspect has a nitride semiconductor barrier layer, a GaN cap layer may be provided on the nitride semiconductor barrier layer as necessary. A thickness of the GaN cap layer in the c-axis direction is preferably 0.1 nm to 10 nm, more preferably 0.5 nm to 8 nm, and still more preferably 1 nm to 5 nm. Here, from the viewpoint of normal device fabrication, the thickness of the GaN cap layer is preferably 0.1 nm or more, more preferably 0.5 nm or more, and still more preferably 1 nm or more. From the viewpoint of reducing the leakage current, the thickness of the GaN cap layer is preferably 10 nm or less, more preferably 8 nm or less, and still more preferably 5 nm or less.

The GaN epitaxial substrate according to the present embodiment in the first aspect is preferably used for producing a nitride semiconductor device, particularly a nitride semiconductor device having a lateral device structure.

In the case where the GaN epitaxial substrate is used for the nitride semiconductor device, one or two or more nitride semiconductor layers may be epitaxially grown on the GaN epitaxial substrate as necessary. The nitride semiconductor is also referred to as a nitride-based Group III-V compound semiconductor, a group III nitride-based compound semiconductor, a GaN-based semiconductor, or the like, and includes not only GaN but also a compound obtained by substituting a part or all of gallium of GaN with other Group 13 elements (B, Al, In, or the like) of the periodic table.

Thereafter, electrodes are provided on the GaN epitaxial substrate in accordance with the type of the nitride semiconductor device to be produced.

A typical example of the nitride semiconductor device having a lateral device structure is a high electron mobility transistor (GaN-HEMT).

### [Method for Producing GaN Epitaxial Substrate]

A method for producing the GaN epitaxial substrate according to the present embodiment in the first aspect is not particularly limited, and one embodiment as an example thereof will be described below. A preferred aspect of the GaN epitaxial substrate obtained by the production method is the same as the preferred aspect described in above-described [GaN Epitaxial Substrate].

The method for producing a GaN epitaxial substrate according to the above one embodiment in the first aspect includes at least a step of preparing a GaN substrate and a step of epitaxially growing a GaN buffer layer on the GaN substrate.

The GaN substrate used for the GaN epitaxial substrate according to the present embodiment in the first aspect may be a GaN substrate having a Fe-doped layer obtained by doping with Fe or a GaN substrate having no Fe-doped layer as described in [GaN Epitaxial Substrate] in the above-described first aspect. In the case where the GaN substrate having no Fe-doped layer is used, it is required to dope the GaN buffer layer with Fe in order to achieve semi-insulating by Fe as described below.

The above GaN substrate may be produced by a known method and used, or a commercially available product may be obtained and used. In the case where a GaN substrate is produced, the above step of preparing a GaN substrate is a step of producing a GaN substrate, and a step of producing a Fe-doped GaN substrate is preferred.

The GaN substrate doped with Fe can be obtained, for example, by growing a Fe-doped GaN crystal on a seed using HVPE and performing processing such as slicing, grinding, and polishing.

### •Method for Forming GaN Buffer Layer

A method for epitaxially growing the GaN buffer layer on the GaN substrate is not particularly limited, and various known methods can be adopted. Preferred examples include the MOCVD method and a molecular beam epitaxy (MBE) method.

In the case where the MOCVD method is used, a raw gas is not particularly limited as long as the raw gas contains a Ga source or an N source for forming GaN, and a known raw gas can be used.

As described above, in the case where the GaN substrate is a GaN substrate doped with Fe, it is not necessary to dope the epitaxially grown GaN buffer layer with Fe, and in the case of the GaN substrate not including a Fe-doped layer obtained by doping with Fe, a region doped with Fe is formed in the GaN epitaxial substrate by doping the epitaxially grown GaN buffer layer with Fe. In this case, it can be said that the method for producing the GaN epitaxial substrate preferably includes a step of doping with Fe in a part of the step of epitaxially growing the GaN buffer layer. The step of doping with Fe is preferably performed before the step of forming a C-containing region described below.

In order for the Fe concentration of the GaN epitaxial substrate according to the present embodiment in the first aspect to satisfy the characteristics of any of the first embodiment to fourth embodiment described above, it is preferable that at least a part of the step of epitaxially growing the GaN buffer layer includes a step of forming a C-containing region having a C concentration of 1 × 10¹⁶ atoms/cm³ or more. The C-containing region is more preferably formed by doping the epitaxially grown GaN buffer layer with C. The above characteristics for the first embodiment in the first aspect are that [Fe]_{B}/[Fe]_{A} is 1/100, and the distance between the point A and the point B is 0.2 µm or less. The above characteristics for the second embodiment in the first aspect are that [Fe]_{B'}/[Fe]_{A'} is 1/10, and the distance between the point A' and the point B' is 0.1 µm or less. The above characteristics for the third embodiment in the first aspect are that the Fe concentration of the point A" is 1 × 10¹⁷ atoms/cm³ or more, the Fe concentration of the point B" is 1 × 10¹⁵ atoms/cm³ or less, and the distance between the point A" and the point B" is 0.2 µm or less. The above characteristics for the fourth embodiment in the first aspect are that the Fe concentration of the point A‴ is 1 × 10¹⁷ atoms/cm³ or more, the Fe concentration of the point B‴ is 1 × 10¹⁶ atoms/cm³ or less, and the distance between the point A‴ and the point B‴ is 0.1 µm or less.

It is preferable to perform doping with C in a region present in the [0001] axis direction relative to the region doped with Fe. Therefore, in the case where the GaN substrate includes the region doped with Fe, the C-containing region is always present in the [0001] axis direction relative to the region doped with Fe. On the other hand, in the case where the epitaxially grown GaN buffer layer includes the region doped with Fe, a step of doping with Fe is preferably performed after the step of doping with Fe is performed.

In the first embodiment to the fourth embodiment of the first aspect, it is preferable to perform doping with C such that the C-containing region includes the point B, the point B', the point B", or the point B‴. It is also preferable to perform doping with C at a position closer to the (000-1) plane than the plane including the point B and parallel to the (0001) plane, the plane including the point B' and parallel to the (0001) plane, the plane including the point B" and parallel to the (0001) plane, or the plane including the point B‴ and parallel to the (0001) plane. In the latter, doping with C is performed between a plane including the point A, the point A', the point A", or the point A‴ and parallel to the (0001) plane and a plane including the point B, the point B', the point B", or the point B‴ and parallel to the (0001) plane.

In the case where the epitaxially grown GaN buffer layer is doped with C, the thickness in the c-axis direction (height in the thickness direction) of the C-containing region in which the C concentration is 1 × 10¹⁶ atoms/cm³ or more is preferably 50 nm to 900 nm as described in the first embodiment of [GaN Epitaxial Substrate] in the above first aspect. Here, the above thickness is preferably 50 nm or more from the viewpoint of normal device fabrication, and is preferably 900 nm or less from the viewpoint of reducing the leakage current.

The C concentration of the C-containing region may be 1 × 10¹⁶ atoms/cm³ or more, and such a concentration may be 5 × 10¹⁶ atoms/cm³ or more, or 1 × 10¹⁷ atoms/cm³ or more.

In order to avoid a significant decrease in crystal quality due to excessive doping, the C concentration of the GaN buffer layer including the C-containing region is preferably 1 × 10¹⁸ atoms/cm³ or less, and may be less than 1 × 10¹⁸ atoms/cm³, 8 × 10¹⁷ atoms/cm³ or less, or 5 × 10¹⁷ atoms/cm³ or less.

A commonly known method can be used for the doping with C. For example, the MOCVD method or the MBE method is preferably used.

In the case where the MOCVD method is used, for example, a hydrocarbon gas such as CH₄ (methane) may be used as the raw gas, and from the viewpoint of simplification, it is preferable to use a raw gas containing a Ga source or an N source for forming GaN. From this viewpoint, it is preferable to use trimethylgallium (TMG) or triethylgallium (TEG) as the raw gas of C, and TMG is more preferred. It is further preferable to use a mixed gas of TMG and ammonia (NH₃) or a mixed gas of TEG and NH₃.

In the case where the mixed gas of trimethylgallium (TMG) and ammonia (NH₃) is used, a supply rate of TMG is preferably 100 µmol/min to 500 µmol/min, and more preferably 200 µmol/min to 300 µmol/min. Here, from the viewpoint of reducing a concentration of an impurity such as Si, the supply rate of TMG is preferably 100 µmol/min or more, and more preferably 200 µmol/min or more. From the viewpoint of film thickness controllability, the supply rate of TMG is preferably 500 µmol/min or less, and more preferably 300 µmol/min or less.

A supply rate ratio represented by TMG:NH₃ is preferably 1:100 to 1:4000, more preferably 1:500 to 1:4000 or 1:100 to 1:2000, and still more preferably 1:500 to 1:2000, from the viewpoint of the controllability of the C concentration.

In the case where doping is performed with C to form a C-containing region and the epitaxially grown GaN buffer layer is also doped with Fe, it is preferable to discontinuously perform doping with Fe and doping with C from the viewpoint of reducing a memory effect during the epitaxial growth. In other words, it is preferable to avoid continuous doping with C after doping with Fe. The term "continuously perform" means that, for example, a doping operation with Fe and a doping operation with C are performed without purging or leaving an interval of several hours or longer between both operations, and the same growth device may be used to perform the doping operation with C after the doping operation with Fe.

In the case where doping with C is performed to form a C-containing region and a substrate having a region doped with Fe is used as a GaN substrate, the doping with Fe and the doping with C are naturally performed discontinuously through a production process.

As described above, as the epitaxial GaN buffer layer, the i-GaN layer may be formed after forming the Fe-doped region obtained by doping with Fe or the C-containing region as necessary. In the case where the GaN epitaxial substrate according to the present embodiment in the first aspect is used for the HEMT, the i-GaN layer is required to be formed because the i-GaN layer functions as a so-called channel layer. The method for forming the i-GaN layer is the same as the method for epitaxially growing the GaN buffer layer except that intentional doping with impurities is not performed. Preferred examples include the MOCVD method and the MBE method.

In the case where the MOCVD method is used for forming the i-GaN layer, for example, a hydrocarbon gas such as CH₄ (methane) may be used as the raw gas, and from the viewpoint of simplification, it is preferable to use a raw gas containing a Ga source or an N source for forming GaN.

In the case where the mixed gas of trimethylgallium (TMG) and ammonia (NH₃) is used, the supply rate of TMG is preferably 50 µmol/min to 250 µmol/min, and more preferably 100 µmol/min to 150 µmol/min. Here, from the viewpoint of reducing a concentration of an impurity such as Si, the supply rate of TMG is preferably 50 µmol/min or more, and more preferably 100 µmol/min or more. From the viewpoint of film thickness controllability, the supply rate of TMG is preferably 250 µmol/min or less, and more preferably 150 µmol/min or less.

A supply rate ratio represented by TMG:NH₃ is preferably 1:400 to 1:16000, more preferably 1:400 to 1:1800 or 1:2000 to 1:16000, and still more preferably 1:2000 to 1:8000 from the viewpoint of reducing the C concentration.

The thickness in the c-axis direction of the i-GaN layer in the GaN buffer layer is the same as that described in the present embodiment of [GaN Epitaxial Substrate] in the first aspect, and is preferably 50 nm to 900 nm. Here, the above thickness is preferably 50 nm or more from the viewpoint of normal device fabrication, and is preferably 900 nm or less from the viewpoint of reducing the leakage current.

### •Method for Forming Nitride Semiconductor Barrier Layer

After the above epitaxial GaN buffer layer is formed, a nitride semiconductor barrier layer may be formed. In the case where the GaN epitaxial substrate according to the present embodiment in the first aspect is used for the HEMT, it is required to form a nitride semiconductor barrier layer to generate a 2DEG. A preferred example of the barrier layer is an AlₓGa₁₋ₓN (0 < x < 1) layer, and may be an AlInGaN layer. The 2DEG is generated in a region sandwiched between the GaN buffer layer and the nitride semiconductor barrier layer.

The method for forming the nitride semiconductor barrier layer is not particularly limited, and a commonly known method may be adopted. Preferred examples include the MOCVD method and the MBE method.

A preferred thickness in the c-axis direction of the nitride semiconductor barrier layer on the GaN buffer layer is the same as that described in the present embodiment of [GaN Epitaxial Substrate] in the first aspect described above.

In the case where the above nitride semiconductor barrier layer is formed, a commonly known layer such as a GaN cap layer can be formed by a commonly known method as necessary.

### <<Second Aspect>>

### [GaN Epitaxial Substrate]

A GaN epitaxial substrate according to a first embodiment in the second aspect includes a GaN substrate and a GaN buffer layer epitaxially grown on the GaN substrate. At least one of the GaN substrate and the GaN buffer layer includes a Fe-doped layer obtained by doping with Fe, the GaN buffer layer includes the C-containing layer, and the C-containing layer is present in the [0001] axis direction relative to the Fe-doped layer and has a C concentration of 1 × 10¹⁶ to 1 × 10¹⁸ atoms/cm³.

The expression "the C-containing layer is present in the [0001] axis direction relative to the Fe-doped layer" means that the C-containing layer is present in the +c-axis direction relative to the Fe-doped layer, that is, in the Ga polar plane direction of the crystal. The same applies to a relationship between the C-containing layer and the GaN region described below, a relationship between the Fe-doped layer and a Fe diffusion-restricting layer or a relationship between the Fe diffusion-restricting layer and the GaN region in the second embodiment described below, and a relationship between the point A and the point B, or a relationship between the point A' and the point B' in the first embodiment and the second embodiment.

The Fe-doped layer obtained by doping with Fe means a region where the Fe concentration is 1 × 10¹⁷ atoms/cm³ or more, and can be distinguished from a case where Fe is unintentionally introduced in the process of producing the GaN epitaxial substrate.

With respect to the Fe-doped layer obtained by doping with Fe, the C-containing layer having a C concentration of 1 × 10¹⁶ to 1 × 10¹⁸ atoms/cm³ is present in the [0001] axis direction relative to the Fe-doped layer, so that the movement of Fe between different regions defined by the C-containing layer is inhibited.

The movement of Fe in the GaN epitaxial substrate is generally caused by thermal diffusion defined by the diffusion equation. Therefore, a concentration distribution of Fe in the GaN epitaxial substrate is originally described by the diffusion equation. However, in the case where the C-containing layer is present, it has been found that a concentration distribution of Fe around the C-containing layer deviates from a behavior predicted by the diffusion equation and shows a steep Fe concentration gradient. Therefore, it is considered that the presence of the C-containing layer effectively inhibits the movement of Fe in the GaN epitaxial substrate.

Depending on the method for producing a GaN epitaxial substrate, C may be introduced into the C-containing layer at a concentration equal to or greater than a certain level due to unintended impurities. in this case, when the C concentration is 1 × 10¹⁶ to 1 × 10¹⁸ atoms/cm³, the effect of the present invention is exhibited. On the other hand, according to the method for producing the GaN epitaxial substrate, the C concentration may not be 1 × 10¹⁶ atoms/cm³ or more only from the impurities. In this case, the C-containing layer is preferably a layer doped with C. Examples of such a production method include the MOCVD method and the molecular beam epitaxy (MBE) method. In the above description, it is not excluded that a C-containing layer is formed by further doping with C after adopting a production method in which C is introduced due to unintended impurities.

The C concentration of the C-containing layer is preferably 1 × 10¹⁶ atoms/cm³ or more and 1 × 10¹⁸ atoms/cm³ or less, more preferably 5 × 10¹⁶ atoms/cm³ or more and less than 1 × 10¹⁸ atoms/cm³, still more preferably 1 × 10¹⁷ atoms/cm³ or more and 8 × 10¹⁷ atoms/cm³ or less, and particularly preferably 1 × 10¹⁷ atoms/cm³ or more and 5 × 10¹⁷ atoms/cm³ or less. Here, the C concentration of the C-containing layer may be 1 × 10¹⁶ atoms/cm³ or more, and from the viewpoint of further inhibiting the movement of Fe, the C concentration of the C-containing layer is preferably 5 × 10¹⁶ atoms/cm³ or more, and more preferably 1 × 10¹⁷ atoms/cm³ or more. The C concentration in the C-containing layer is 1 × 10¹⁸ atoms/cm³ or less, preferably less than 1 × 10¹¹ atoms/cm³, more preferably 8 × 10¹⁷ atoms/cm³ or less, and still more preferably 5 × 10¹⁷ atoms/cm³ or less, from the viewpoint of preventing the occurrence of defects such as threading dislocations and from the viewpoint of preventing the leakage current caused by C.

The thickness of the C-containing layer in the c-axis direction is preferably 50 nm to 900 nm, more preferably 100 nm to 600 nm, and still more preferably 200 nm to 500 nm. Here, from the viewpoint of normal device fabrication, the above thickness of the C-containing layer is preferably 50 nm or more, more preferably 100 nm or more, and still more preferably 200 nm or more. From the viewpoint of reducing the leakage current, the above thickness of the C-containing layer is preferably 900 nm or less, more preferably 600 nm or less, and still more preferably 500 nm or less.

The thickness of the C-containing layer in the c-axis direction is preferably 5% to 90%, more preferably 10% to 80%, and still more preferably 20% to 70% of a total film thickness of the GaN buffer layer. Here, from the viewpoint of normal device fabrication, the thickness of the C-containing layer in the c-axis direction is preferably 5% or more, more preferably 10% or more, and still more preferably 20% or more of the total film thickness of the GaN buffer layer. From the same viewpoint, the above thickness is preferably 90% or less, more preferably 80% or less, and still more preferably 70% or less of a total film thickness of the GaN buffer layer. In the case where the GaN buffer layer includes a Fe-doped layer, a C-containing region, an i-GaN layer, and the like as described below, the total thickness of the GaN buffer layer refers to a total thickness, in the c-axis direction, including the Fe-doped layer, the C-containing layer, the i-GaN layer, and the like.

The Fe-doped layer obtained by doping with Fe may be included in at least one of the GaN substrate and the GaN buffer layer, and is preferably included in the GaN substrate from the viewpoint of ease of production.

The ease of the above production will be described. In the case where the Fe-doped layer obtained by doping with Fe is present in the GaN buffer layer, both the Fe-doped layer and the C-containing layer are included in the GaN buffer layer epitaxially grown by the MOCVD method or the like. During the formation of the Fe-doped layer, a Fe dopant gas used for doping with Fe may remain in a reaction tube, and Fe may be unintentionally incorporated when a region subsequent to the Fe-doped layer is formed. When such unintended incorporation of Fe occurs, it is difficult to obtain the effect of the present invention in which the movement of Fe is effectively inhibited by adopting a configuration including a C-containing layer having a specific C concentration, and further steps are required to control the concentration gradient of Fe. In contrast, when the Fe-doped layer is present in the GaN substrate, the unintended incorporation of Fe can be prevented, and therefore, the GaN epitaxial substrate according to the present embodiment in the second aspect can be easily produced.

In the case where the Fe-doped layer obtained by doping with Fe is included in the GaN buffer layer and the C-containing layer is a layer doped with C, it is preferable to discontinuously perform the doping with Fe during the formation of the Fe-doped layer and the doping with C during the formation of the C-containing layer from the viewpoint of reducing the memory effect during the epitaxial growth. In other words, it is preferable to avoid continuous doping with C after doping with Fe. The term "continuously perform" means that, for example, purging was not performed or an interval of several hours or longer was not left between a doping operation with Fe and a doping operation with C, and the same growth device may be used to perform the doping operation with C after the doping operation with Fe.

The Fe concentration of the Fe-doped layer obtained by doping with Fe is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, the Fe concentration of the Fe-doped layer is 1 × 10¹⁷ atoms/cm³ or more, and from the viewpoint of ensuring sufficient semi-insulating properties, the Fe concentration of the Fe-doped layer is preferably 5 × 10¹⁷ atoms/cm³ or more, and more preferably 1 × 10¹⁸ atoms/cm³ or more. In addition, from the viewpoint of maintaining good crystal quality, the Fe concentration of the Fe-doped layer is preferably 1 × 10²⁰ atoms/cm³ or less, more preferably 1 × 10¹⁹ atoms/cm³ or less, and still more preferably 5 × 10¹⁸ atoms/cm³ or less.

The thickness of the Fe-doped layer in the c-axis direction is preferably 50 µm to 500 µm, more preferably 80 µm to 450 µm, and still more preferably 100 µm to 400 µm. Here, from the viewpoint of reducing the drain leakage current during the transistor operation, the above thickness of the Fe-doped layer is preferably 50 µm or more, more preferably 80 µm or more, and still more preferably 100 µm or more. From the viewpoint of shortening a thinning time of a substrate in a chip process, the thickness of the Fe-doped layer is preferably 500 µm or less, more preferably 450 µm or less, and still more preferably 400 µm or less.

In the case where the GaN substrate includes the Fe-doped layer, an upper end surface of the Fe-doped layer is preferably present at a position coincident with the (0001) surface of the GaN substrate. A thickness of the Fe-doped layer in a c-axis direction is not required to coincide with the thickness of the GaN substrate in the c-axis direction. For example, a thickness of the entire GaN substrate is 400 µm, whereas a thickness of the Fe-doped layer is sufficient if it is included in the top 100 µm of the GaN substrate. Of course, the thickness of the Fe-doped layer is not limited to the above, and the case where the Fe-doped layer has a thickness larger or smaller than the above thickness is not excluded at all. In addition, a GaN substrate in which the entire GaN substrate in the thickness direction is formed by the Fe-doped layer may be used.

In the case where the GaN substrate includes the Fe-doped layer, the thickness of the Fe-doped layer may be 50 µm to 500 µm. In the case where the GaN substrate includes the Fe-doped layer, the thickness of the Fe-doped layer may be 50 µm or more, 80 µm or more, or 100 µm or more. On the other hand, the thickness of the Fe-doped layer may be 500 µm or less.

In the case where the GaN substrate includes the Fe-doped layer, the C concentration of the Fe-doped layer is preferably 5 × 10¹⁶ atoms/cm³ or less. In the case where the GaN substrate includes the Fe-doped layer, the C concentration of the Fe-doped layer may be 4 × 10¹⁶ atoms/cm³ or less, 3 × 10¹⁶ atoms/cm³ or less, 2 × 10¹⁶ atoms/cm³ or less, or less than 1 × 10¹⁶ atoms/cm³.

A Fe concentration of the GaN region present in the above C-containing layer or the GaN region present in the [0001] axis direction relative to the C-containing layer in the GaN buffer layer is preferably less than 1 × 10¹⁷ atoms/cm³, more preferably 1 × 10¹⁶atoms/cm³ or less, still more preferably 1 × 10¹⁵atoms/cm³ or less, yet still more preferably 5 × 10¹⁴atoms/cm³ or less, and particularly preferably 1 × 10¹⁴atoms/cm³ or less, from the viewpoint that the concentration gradient of Fe is steep in relation to the Fe-doped layer and the diffusion of Fe is more suitably inhibited.

A lower limit of the Fe concentration of the GaN region is not particularly limited, and the detection limit of Fe generally coincides with the lower limit. In the case where the GaN buffer layer includes the i-GaN layer described below, a region having a C concentration less than 1 × 10¹⁶ atoms/cm³, which is a GaN region present in the [0001] axis direction relative to the above C-containing layer, may have the same meaning as the i-GaN layer.

The GaN epitaxial substrate according to the first embodiment in the second aspect preferably includes the point A and point B satisfying the following specific conditions. The point A is included in the GaN substrate or the GaN buffer layer, and the point B is included in the GaN buffer layer. The point B is positioned on a straight line parallel to the [0001] axis passing through the point A, and is present in the [0001] axis direction relative to the point A. A ratio ([Fe]_{B}/[Fe]_{A}) of a Fe concentration of the point B to a Fe concentration of the point A [Fe]_{A} is 1/100, and a distance between the point A and the point B is 0.2 µm or less.

In one aspect of the above point A and point B, it is preferable that the point B is present in the C-containing layer or the C-containing layer is present between the point A and the point B. That is, it is preferable that the C-containing layer includes the point B, or is positioned closer to the (000-1) plane than a plane including the point B and parallel to the (0001) plane.

The point A is preferably present in the Fe-doped layer. The point B is preferably present in the GaN buffer layer, and is more preferably included in the C-containing layer or the GaN region. However, the point A and point B are not limited to the above aspects.

The description that the distance between the point A and the point B at which [Fe]_{B}/[Fe]_{A} is 1/100 is 0.2 µm or less means that a concentration gradient of Fe between the two points, the point A and the point B, is steep, and the diffusion of Fe is suitably inhibited. Accordingly, the diffusion of Fe to a region where a 2DEG is generated can be prevented in a GaN-HEMT structure while ensuring a semi-insulating property of Fe.

The distance between the point A and the point B may be 0.2 µm or less, and is preferably 0.15 µm or less, more preferably 0.13 µm or less, and still more preferably 0.12 µm or less from the viewpoint of making the concentration gradient of Fe steeper. The distance between the point A and the point B is preferably as short as possible, and is generally 0.01 µm or more from the viewpoint of achievability.

The Fe concentration of the point A [Fe]_{A} is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, from the viewpoint of ensuring sufficient semi-insulating properties, [Fe]_{A} is preferably 1 × 10¹⁷ atoms/cm³ or more, more preferably 5 × 10¹⁷ atoms/cm³ or more, and still more preferably 1 × 10¹⁸ atoms/cm³ or more. From the viewpoint of maintaining good crystal quality, [Fe]a is preferably 1 × 10²⁰ atoms/cm³ or less, more preferably 1 × 10¹⁹ atoms/cm³ or less, and still more preferably 5 × 10¹⁸ atoms/cm³ or less.

The Fe concentration of the point B is 1/100 of the Fe concentration of the point A [Fe]_{A}, and therefore, a preferable range of [Fe]_{B} may change depending on [Fe]_{A}.

The GaN epitaxial substrate according to the first embodiment in the second aspect preferably includes the point A' and the point B' satisfying the following specific conditions. The point A' is included in the GaN substrate or the GaN buffer layer, and the point B' is included in the GaN buffer layer. The point B' is positioned on a straight line parallel to the [0001] axis passing through the point A', and is present in the [0001] axis direction relative to the point A'. A ratio ([Fe]_{B'}/[Fe]_{A'}) of a Fe concentration of the point B' [Fe]_{B'} to a Fe concentration of the point A' [Fe]_{A'} is 1/10, and a distance between the point A' and the point B' is 0.15 µm or less.

In one aspect of the above point A' and point B', it is preferable that the point B' is present in the C-containing layer or the C-containing layer is present between the point A' and the point B'. That is, it is preferable that the C-containing layer includes the point B', or is positioned closer to the (000-1) plane than a plane including the point B' and parallel to the (0001) plane.

The point A' is preferably included in the Fe-doped layer. The point B' is preferably included in the GaN buffer layer, and is more preferably included in the C-containing layer or the GaN region. However, the point A' and the point B' are not limited to the above-described aspects.

The description that the distance between the point A' and the point B' at which [Fe]_{B'}/[Fe]_{A'} is 1/10 is 0.15 µm or less means that a concentration gradient of Fe between the two points, the point A' and the point B', is steep, and the diffusion of Fe is suitably inhibited. Accordingly, the diffusion of Fe to a region where a 2DEG is generated can be prevented in a GaN-HEMT structure while ensuring a semi-insulating property of Fe.

The distance between the point A' and the point B' may be 0.15 µm or less, and from the viewpoint of making the concentration gradient of Fe steeper, the distance is preferably 0.13 µm or less, more preferably 0.10 µm or less, still more preferably 0.08 µm or less, and particularly preferably 0.05 µm or less. The distance between the point A' and the point B' is preferably as short as possible, and is generally 0.01 µm or more from the viewpoint of achievability.

The Fe concentration of the point A' [Fe]_{A'} is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, from the viewpoint of ensuring sufficient semi-insulating properties, [Fe]_{A'} is preferably 1 × 10¹⁷ atoms/cm³ or more, more preferably 5 × 10¹⁷ atoms/cm³ or more, and still more preferably 1 × 10¹⁸ atoms/cm³ or more. From the viewpoint of maintaining good crystal quality, [Fe]_{A'} is preferably 1 × 10²⁰ atoms/cm³ or less, more preferably 1 × 10¹⁹ atoms/cm³ or less, and still more preferably 5 × 10¹⁸ atoms/cm³ or less.

The Fe concentration of the point B' [Fe]_{B'} is 1/10 of the Fe concentration of the point A' [Fe]_{A'}, and therefore, a preferable range of [Fe]_{B'} may change depending on [Fe]_{A'}.

A GaN epitaxial substrate according to the second embodiment in the second aspect includes a GaN substrate and a GaN buffer layer epitaxially grown on the above GaN substrate. The GaN substrate or the GaN buffer layer includes a Fe-doped layer obtained by doping with Fe, and the GaN buffer layer includes a Fe diffusion-restricting layer that is present in the [0001] axis direction relative to the Fe-doped layer and restricts the diffusion of Fe. The Fe diffusion-restricting layer is a layer containing C.

The Fe-doped layer obtained by doping with Fe means a region where the Fe concentration is 1 × 10¹⁷ atoms/cm³ or more, and can be distinguished from a case where Fe is unintentionally introduced in the process of producing the GaN epitaxial substrate.

With respect to the Fe-doped layer obtained by doping with Fe, the Fe diffusion-restricting layer containing C is present in the [0001] axis direction relative to the Fe-doped layer, so that the movement of Fe between different regions defined by the Fe diffusion-restricting layer is inhibited.

The movement of Fe in the GaN epitaxial substrate is generally caused by thermal diffusion defined by the diffusion equation. Therefore, a concentration distribution of Fe in the GaN epitaxial substrate is originally described by the diffusion equation. However, in the case where the Fe diffusion-restricting layer is present, it has been found that a concentration distribution of Fe around the Fe diffusion-restricting layer deviates from a behavior predicted by the diffusion equation and shows a steep Fe concentration gradient. Therefore, it is considered that the presence of the Fe diffusion-restricting layer effectively inhibits the movement of Fe in the GaN epitaxial substrate.

Depending on the method for producing a GaN epitaxial substrate, C may be introduced into the Fe diffusion-restricting layer at a concentration equal to or greater than a certain level due to unintended impurities. In this case, when the C concentration is equal to or greater than the certain level, the effect of the present invention is exhibited. On the other hand, according to the method for producing the GaN epitaxial substrate, the C concentration may not exhibit the effect of the present invention only by the impurities. In this case, the Fe diffusion-restricting layer is preferably a layer doped with C. Examples of such a production method include the MOCVD method and the molecular beam epitaxy (MBE) method. In the above description, it is not excluded that a C-containing layer is formed by further doping with C after adopting a production method in which C is introduced due to unintended impurities.

The C concentration of the Fe diffusion-restricting layer is preferably 1 × 10¹⁶ atoms/cm³ to 1 × 10¹⁸ atoms/cm³, more preferably 5 × 10¹⁶ atoms/cm³ or more and less than 1 × 10¹⁸ atoms/cm³, still more preferably 1 × 10¹⁷ atoms/cm³ or more and 8 × 10¹⁷ atoms/cm³ or less, and yet still more preferably 1 × 10¹⁷ atoms/cm³ or more and 5 × 10¹⁷ atoms/cm³ or less. Here, the C concentration of the Fe diffusion-restricting layer is preferably 1 × 10¹⁶ atoms/cm³ or more, more preferably 5 × 10¹⁶ atoms/cm³ or more, and still more preferably 1 × 10¹⁷ atoms/cm³ or more, from the viewpoint of further inhibiting the movement of Fe. The C concentration of the Fe diffusion-restricting layer is preferably 1 × 10¹⁸ atoms/cm³ or less, more preferably less than 1 × 10¹¹ atoms/cm³, still more preferably 8 × 10¹⁷ atoms/cm³ or less, and yet still more preferably 5 × 10¹⁷ atoms/cm³ or less, from the viewpoint of preventing the occurrence of defects such as threading dislocations and from the viewpoint of preventing the leakage current caused by C.

The thickness of the Fe diffusion-restricting layer in the c-axis direction is preferably 50 nm to 900 nm, more preferably 100 nm to 600 nm, and still more preferably 200 nm to 500 nm. Here, from the viewpoint of normal device fabrication, the thickness of the Fe diffusion-restricting layer is preferably 50 nm or more, more preferably 100 nm or more, and still more preferably 200 nm or more. From the viewpoint of reducing the leakage current, the thickness of the Fe diffusion-restricting layer is preferably 900 nm or less, more preferably 600 nm or less, and still more preferably 500 nm or less.

The thickness of the Fe diffusion-restricting layer in the c-axis direction is preferably 5% to 90%, more preferably 10% to 80%, and still more preferably 20% to 70% of a total film thickness of the GaN buffer layer. From the viewpoint of normal device fabrication, the thickness of the Fe diffusion-restricting layer is preferably 5% or more, more preferably 10% or more, and still more preferably 20% or more of the total film thickness of the GaN buffer layer. From the same viewpoint, the above thickness is preferably 90% or less, more preferably 80% or less, and still more preferably 70% or less of a total film thickness of the GaN buffer layer. In the case where the GaN buffer layer includes a Fe-doped layer, a C-containing region, an i-GaN layer, and the like as described below, the total thickness of the GaN buffer layer refers to a total thickness, in the c-axis direction, including the Fe-doped layer, the Fe diffusion-restricting layer, the i-GaN layer, and the like.

The Fe-doped layer obtained by doping with Fe may be included in either the GaN substrate or the GaN buffer layer, and is preferably included in the GaN substrate from the viewpoint of ease of production.

The above ease of production is the same as the Fe-doped layer of the first embodiment in the second aspect.

The Fe concentration of the Fe-doped layer obtained by doping with Fe is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, the Fe concentration of the Fe-doped layer is 1 × 10¹⁷ atoms/cm³ or more, and from the viewpoint of ensuring sufficient semi-insulating properties, the Fe concentration of the Fe-doped layer is preferably 5 × 10¹⁷ atoms/cm³ or more, and more preferably 1 × 10¹⁸ atoms/cm³ or more. In addition, from the viewpoint of maintaining good crystal quality, the Fe concentration of the Fe-doped layer is preferably 1 × 10²⁰ atoms/cm³ or less, more preferably 1 × 10¹⁹ atoms/cm³ or less, and still more preferably 5 × 10¹¹ atoms/cm³ or less.

The thickness of the Fe-doped layer in the c-axis direction is preferably 50 nm to 500 nm, more preferably 80 nm to 450 nm, and still more preferably 100 nm to 400 nm. Here, from the viewpoint of reducing the drain leakage current during the transistor operation, the thickness of the Fe-doped layer is preferably 50 µm or more, more preferably 80 µm or more, and still more preferably 100 µm or more. From the viewpoint of shortening a thinning time of a substrate in a chip process, the thickness of the Fe-doped layer is preferably 500 µm or less, more preferably 450 µm or less, and still more preferably 400 µm or less.

In the case where the GaN substrate includes the Fe-doped layer, an upper end surface of the Fe-doped layer is preferably present at a position coincident with the (0001) surface of the GaN substrate. A thickness of the Fe-doped layer in a c-axis direction is not required to coincide with the thickness of the GaN substrate in the c-axis direction. For example, a thickness of the entire GaN substrate is 400 µm, whereas a thickness of the Fe-doped layer is sufficient if it is included in the top 100 µm of the GaN substrate. Of course, the thickness of the Fe-doped layer is not limited to the above, and the case where the Fe-doped layer has a thickness larger or smaller than the above thickness is not excluded at all. In addition, a GaN substrate in which the entire GaN substrate in the thickness direction is formed by the Fe-doped layer may be used.

A Fe concentration of the GaN region present in the above Fe diffusion-restricting layer or the GaN region present in the [0001] axis direction relative to the Fe diffusion-restricting layer in the GaN buffer layer is preferably less than 1 × 10¹⁷ atoms/cm³, more preferably 1 × 10¹⁶atoms/cm³ or less, still more preferably 1 × 10¹⁵atoms/cm³ or less, yet still more preferably 5 × 10¹⁴atoms/cm³ or less, and particularly preferably 1 × 10¹⁴atoms/cm³ or less, from the viewpoint that the concentration gradient of Fe is steep in relation to the Fe-doped layer and the diffusion of Fe is more suitably inhibited. A lower limit of the Fe concentration of the GaN region is not particularly limited, and the detection limit of Fe generally coincides with the lower limit. In the case where the GaN buffer layer includes the i-GaN layer described below, a region having a C concentration less than 1 × 10¹⁶ atoms/cm³, which is a GaN region present in the [0001] axis direction relative to the above Fe diffusion-restricting layer, may have the same meaning as the i-GaN layer.

The GaN epitaxial substrate according to the second embodiment in the second aspect preferably includes the point A and point B satisfying the following specific conditions. The point A is included in the GaN substrate or the GaN buffer layer, and the point B is included in the GaN buffer layer. The point B is positioned on a straight line parallel to the [0001] axis passing through the point A, and is present in the [0001] axis direction relative to the point A. A ratio ([Fe]_{B}/[Fe]_{A}) of a Fe concentration of the point B [Fe]_{B} to a Fe concentration of the point A [Fe]_{A} is 1/100, and a distance between the point A and the point B is 0.2 µm or less.

The GaN epitaxial substrate according to the second embodiment in the second aspect preferably includes the point A' and the point B' satisfying the following specific conditions. The point A' is included in the GaN substrate or the GaN buffer layer, and the point B' is included in the GaN buffer layer. The point B' is positioned on a straight line parallel to the [0001] axis passing through the point A', and is present in the [0001] axis direction relative to the point A'. A ratio ([Fe]_{B'}/[Fe]_{A'}) of a Fe concentration of the point B' [Fe]_{B'} to a Fe concentration of the point A' [Fe]_{A'} is 1/10, and a distance between the point A' and the point B' is 0.15 µm or less.

Preferred aspects of the above points A, B, A', and B' are the same as the preferred aspects of the above points A, B, A', and B' of the first embodiment in the above-described second aspect, respectively.

In any embodiment of the first embodiment and the second embodiment (hereinafter, may be referred to as "the present embodiment") in the above second aspect, the GaN epitaxial substrate also includes a GaN buffer layer epitaxially grown on the GaN substrate.

In the present embodiment of the second aspect, a GaN substrate is used instead of a SiC substrate or the like which has been widely used in the past. Accordingly, a defect is less likely to occur at an interface with a GaN buffer layer to be subsequently formed, and a high-concentration carrier compensation layer for preventing a leakage current is unnecessary, so that a drain leakage current when a transistor operation of the GaN-HEMT is performed can be prevented.

A total donor impurity concentration of the GaN substrate according to the present embodiment in the second aspect is preferably less than 4.0 × 10¹⁶ atoms/cm³, and more preferably less than 2.0 × 10¹⁶ atoms/cm³ in order to reduce the doping concentration of the compensation impurities.

The total donor impurity concentration is the sum of concentrations of donor impurities contained in the GaN substrate according to the present embodiment in the second aspect. As impurities acting as donors for GaN, O (oxygen), Si (silicon), S (sulfur), Ge (germanium), Sn (tin), and the like are known. The total donor impurity concentration is determined by SIMS.

In two large-area surfaces of the GaN substrate, that is, a pair of main surfaces thereof, the (0001) plane is used as a front surface for epitaxial growth of a nitride semiconductor layer including the GaN buffer layer. The (0001) plane of the GaN substrate is mirror-finished, and the root mean square (RMS) roughness measured with an atomic force microscope (AFM) is generally less than 2 nm, preferably less than 1 nm, and more preferably less than 0.5 nm in a measurement range of 2 µm × 2 µm.

The (000-1) plane of the GaN substrate is a back surface, and therefore, the plane may be mirror-finished or rough-finished.

### •i-GaN Layer

In the present embodiment in the second aspect, the GaN buffer layer preferably has an i-GaN layer in the [0001] axis direction relative to the C-containing layer or the Fe diffusion-restricting layer. The i-GaN layer is more preferably disposed directly on the C-containing layer or the Fe diffusion-restricting layer. The expression "has an i-GaN layer in the [0001] axis direction relative to the C-containing layer or the Fe diffusion-restricting layer" means that the i-GaN layer is present in the +c-axis direction relative to the C-containing layer or the Fe diffusion-restricting layer, that is, in the Ga polar plane direction of the crystal. The i-GaN layer is a crystal layer made of GaN epitaxially grown without intentionally performing doping with impurities, and is distinguished from the C-containing layer or the Fe diffusion-restricting layer by the C concentration. That is, the C concentration of the i-GaN layer is less than 1 × 10¹⁶ atoms/cm³. In the case where the GaN epitaxial substrate according to the present embodiment in the second aspect is used for the HEMT, the i-GaN layer functions as a so-called channel layer.

A thickness of the GaN buffer layer in the c-axis direction is ideally as thin as possible to reduce the drain leakage current during the HEMT operation. The thickness in the c-axis direction of the i-GaN layer in the GaN buffer layer is preferably 50 nm to 900 nm, more preferably 100 nm to 600 nm, and still more preferably 200 nm to 500 nm. Here, from the viewpoint of normal device fabrication, the above thickness of the i-GaN layer is preferably 50 nm or more, more preferably 100 nm or more, and still more preferably 200 nm or more. From the viewpoint of reducing the leakage current, the above thickness of the i-GaN layer is preferably 900 nm or less, more preferably 600 nm or less, and still more preferably 500 nm or less.

An upper end surface of the i-GaN layer in the GaN buffer layer preferably coincides with the upper end surface of the GaN buffer layer.

### •Nitride Semiconductor Barrier Layer

The GaN epitaxial substrate according to the present embodiment in the second aspect preferably further has a nitride semiconductor barrier layer on the GaN buffer layer, and it is more preferable that the GaN buffer layer has the i-GaN layer and further has a nitride semiconductor barrier layer on the i-GaN layer. A preferred example of the nitride semiconductor barrier layer is an AlₓGa₁₋ₓN (0 < x < 1) layer, and may be an AlInGaN layer. A 2DEG is generated in a region sandwiched between the i-GaN layer and the nitride semiconductor barrier layer.

As a typical example, in a heterostructure of AlₓGa₁₋ₓN (0 < x < 1)/GaN formed on a GaN substrate having a (0001) plane as a main surface, a 2DEG is generated at a hetero interface due to spontaneous polarization and piezoelectric polarization, and a sheet carrier concentration of about 1×10¹³ cm⁻² or more can be obtained without doping with any substance, so that a radio frequency operation is implemented. Therefore, in the case where the GaN epitaxial substrate according to the present embodiment in the second aspect is used for the HEMT, it is essential to include the nitride semiconductor barrier layer.

The thickness of the nitride semiconductor barrier layer in the c-axis direction is preferably 1 nm to 50 nm, more preferably 5 nm to 40 nm, and still more preferably 10 nm to 30 nm. Here, from the viewpoint of normal device fabrication, the above thickness of the nitride semiconductor barrier layer is preferably 1 nm or more, more preferably 5 nm or more, and still more preferably 10 nm or more. From the viewpoint of reducing the leakage current, the above thickness of the nitride semiconductor barrier layer is preferably 50 nm or less, more preferably 40 nm or less, and still more preferably 30 nm or less.

### •GaN Cap Layer

In the case where the GaN epitaxial substrate according to the present embodiment in the second aspect has a nitride semiconductor barrier layer, a GaN cap layer may be provided on the nitride semiconductor barrier layer as necessary. A thickness of the GaN cap layer in the c-axis direction is preferably 0.1 nm to 10 nm, more preferably 0.5 nm to 8 nm, and still more preferably 0.5 nm to 5 nm. Here, from the viewpoint of normal device fabrication, the above thickness of the GaN cap layer is preferably 0.1 nm or more, more preferably 0.5 nm or more, and still more preferably 1 nm or more. From the viewpoint of reducing the leakage current, the above thickness of the GaN cap layer is preferably 10 nm or less, more preferably 8 nm or less, and still more preferably 5 nm or less.

The GaN epitaxial substrate according to the present embodiment in the second aspect is preferably used for producing a nitride semiconductor device, particularly a nitride semiconductor device having a lateral device structure.

In the case where the GaN epitaxial substrate is used for the nitride semiconductor device, one or two or more nitride semiconductor layers may be epitaxially grown on the GaN epitaxial substrate as necessary. The nitride semiconductor is also referred to as a nitride-based Group III-V compound semiconductor, a group III nitride-based compound semiconductor, a GaN-based semiconductor, or the like, and includes not only GaN but also a compound obtained by substituting a part or all of gallium of GaN with other Group 13 elements (B, Al, In, or the like) of the periodic table.

Thereafter, electrodes are provided on the GaN epitaxial substrate in accordance with the type of the nitride semiconductor device to be produced.

A typical example of the nitride semiconductor device having a lateral device structure is a high electron mobility transistor (GaN-HEMT).

### [Method for Producing GaN Epitaxial Substrate]

A method for producing the GaN epitaxial substrate according to the present embodiment in the second aspect is not particularly limited, and one embodiment as an example thereof will be described below. A preferred aspect of the GaN epitaxial substrate obtained by the production method is the same as the preferred aspect described in above-described [GaN Epitaxial Substrate].

The method for producing a GaN epitaxial substrate according to the above one embodiment in the second aspect includes at least a step of preparing a GaN substrate and a step of epitaxially growing a GaN buffer layer on the GaN substrate.

The GaN substrate used for the GaN epitaxial substrate according to the present embodiment in the second aspect may be a GaN substrate having a Fe-doped layer obtained by doping with Fe or a GaN substrate having no Fe-doped layer as described in [GaN Epitaxial Substrate] in the above-described second aspect. In the case where the GaN substrate having no Fe-doped layer is used, it is required to dope the GaN buffer layer with Fe in order to achieve semi-insulating by Fe as described below.

The above GaN substrate may be produced by a known method and used, or a commercially available product may be obtained and used. In the case where a GaN substrate is produced, the above step of preparing a GaN substrate is a step of producing a GaN substrate, and a step of producing a Fe-doped GaN substrate is preferred.

The GaN substrate doped with Fe can be obtained, for example, by growing a Fe-doped GaN crystal on a seed using HVPE and performing processing such as slicing, grinding, and polishing.

### •Method for Forming GaN Buffer Layer

A method for epitaxially growing the GaN buffer layer on the GaN substrate is not particularly limited, and various known methods can be adopted. Preferred examples include the MOCVD method and a molecular beam epitaxy (MBE) method.

In the case where the MOCVD method is used, a raw gas is not particularly limited as long as the raw gas contains a Ga source or an N source for forming GaN, and a known raw gas can be used.

As described above, in the case where the GaN substrate is a GaN substrate doped with Fe, it is not necessary to dope the epitaxially grown GaN buffer layer with Fe, and in the case of the GaN substrate not including a Fe-doped layer obtained by doping with Fe, a region doped with Fe is formed in the GaN epitaxial substrate by doping the epitaxially grown GaN buffer layer with Fe. In this case, it can be said that the method for producing the GaN epitaxial substrate preferably includes a step of doping with Fe in a part of the step of epitaxially growing the GaN buffer layer. The step of doping with Fe is preferably performed before the step of forming a C-containing region described below.

In order for the Fe concentration of the GaN epitaxial substrate according to the present embodiment in the second aspect to satisfy the preferred characteristics of the first embodiment and the second embodiment in the second aspect described above, it is preferable to perform a step of doping the epitaxially grown GaN buffer layer with C so as to include a C-containing layer and a Fe diffusion-restricting layer containing C. The preferred characteristics of the first embodiment and the second embodiment in the second aspect are that the Fe concentration of the Fe-doped layer is 1 × 10¹⁷ atoms/cm³ or more, and the Fe concentration of the GaN region present in the above C-containing layer or the GaN region present in the [0001] axis direction relative to the C-containing layer is 1 × 10¹⁶ atoms/cm³ or less.

It is preferable to perform doping with C in a region present in the [0001] axis direction relative to the region doped with Fe. Therefore, in the case where the GaN substrate includes the region doped with Fe, the C-containing layer or the Fe diffusion-restricting layer is always present in the [0001] axis direction relative to the region doped with Fe. On the other hand, in the case where the epitaxially grown GaN buffer layer includes the region doped with Fe, it is preferable to perform doping with C after doping with Fe.

In the first embodiment and the second embodiment in the second aspect, it is preferable to perform doping with C such that the C-containing layer or the Fe diffusion-restricting layer includes the point B or the point B'. It is also preferable to perform doping with C at a position closer to the (000-1) plane than the plane including the point B and parallel to the (0001) plane or the plane including the point B' and parallel to the (0001) plane. In the latter, doping with C is performed between a plane including the point A or the point A' and parallel to the (0001) plane and a plane including the point B or the point B' and parallel to the (0001) plane.

In the case where the epitaxially grown GaN buffer layer is doped with C, the thickness in the c-axis direction (height in the thickness direction) of the C-containing layer or the Fe diffusion-restricting layer is preferably 50 nm to 900 nm as described in [GaN Epitaxial Substrate] in the above second aspect. Here, the above thickness is preferably 50 nm or more from the viewpoint of normal device fabrication, and is preferably 900 nm or less from the viewpoint of reducing the leakage current.

The C concentration of the C-containing layer or the Fe diffusion-restricting layer may be 1 × 10¹⁶ atoms/cm³ or more, and such a concentration may be 5 × 10¹⁶ atoms/cm³ or more, or 1 × 10¹⁷ atoms/cm³ or more.

In order to avoid a significant decrease in crystal quality due to excessive doping, the C concentration of the GaN buffer layer including the C-containing layer or the Fe diffusion-restricting layer is preferably 1 × 10¹⁸ atoms/cm³ or less, and may be less than 1 × 10¹⁸ atoms/cm³, 8 × 10¹⁷ atoms/cm³ or less, or 5 × 10¹⁷ atoms/cm³ or less.

A commonly known method can be used for the doping with C. For example, the MOCVD method or the MBE method is preferably used.

In the case where the MOCVD method is used, for example, a hydrocarbon gas such as CH₄ (methane) may be used as the raw gas, and from the viewpoint of simplification, it is preferable to use a raw gas containing a Ga source or an N source for forming GaN. From this viewpoint, it is preferable to use trimethylgallium (TMG) or triethylgallium (TEG) as the raw gas of C, and TMG is more preferred. It is further preferable to use a mixed gas of TMG and ammonia (NH₃) or a mixed gas of TEG and NH₃.

In the case where the mixed gas of trimethylgallium (TMG) and ammonia (NH₃) is used, a supply rate of TMG is preferably 100 µmol/min to 500 µmol/min, and more preferably 200 µmol/min to 300 µmol/min. Here, from the viewpoint of reducing a concentration of an impurity such as Si, the supply rate of TMG is preferably 100 µmol/min or more, and more preferably 200 µmol/min or more. From the viewpoint of film thickness controllability, the supply rate of TMG is preferably 500 µmol/min or less, and more preferably 300 µmol/min or less.

A supply rate ratio represented by TMG:NH₃ is preferably 1:100 to 1:4000, more preferably 1:500 to 1:4000 or 1:100 to 1:2000, and still more preferably 1:500 to 1:2000, from the viewpoint of the controllability of the C concentration.

In the case where doping is performed with C to form a C-containing region and the epitaxially grown GaN buffer layer is also doped with Fe, it is preferable to discontinuously perform doping with Fe and doping with C from the viewpoint of reducing a memory effect during the epitaxial growth. In other words, it is preferable to avoid continuous doping with C after doping with Fe. The term "continuously perform" means that, for example, a doping operation with Fe and a doping operation with C are performed without purging or leaving an interval of several hours or longer between both operations, and the same growth device may be used to perform the doping operation with C after the doping operation with Fe.

In the case where doping with C is performed to form a C-containing region and a substrate having a region doped with Fe is used as a GaN substrate, the doping with Fe and the doping with C are naturally performed discontinuously through a production process.

As described above, as the epitaxial GaN buffer layer, the i-GaN layer may be formed after forming the Fe-doped region obtained by doping with Fe or the C-containing region as necessary. In the case where the GaN epitaxial substrate according to the present embodiment in the second aspect is used for the HEMT, the i-GaN layer is required to be formed because the i-GaN layer functions as a so-called channel layer. The method for forming the i-GaN layer is the same as the method for epitaxially growing the GaN buffer layer except that intentional doping with impurities is not performed. Preferred examples include the MOCVD method and the MBE method.

In the case where the MOCVD method is used for forming the i-GaN layer, for example, a hydrocarbon gas such as CH₄ (methane) may be used as the raw gas, and from the viewpoint of simplification, it is preferable to use a raw gas containing a Ga source or an N source for forming GaN.

In the case where the mixed gas of trimethylgallium (TMG) and ammonia (NH₃) is used, a supply rate of TMG is preferably 50 µmol/min to 250 µmol/min, and more preferably 100 µmol/min to 150 µmol/min. Here, from the viewpoint of reducing a concentration of an impurity such as Si, the supply rate of TMG is preferably 50 µmol/min or more, and more preferably 100 µmol/min or more. From the viewpoint of film thickness controllability, the supply rate of TMG is preferably 250 µmol/min or less, and more preferably 150 µmol/min or less.

A supply rate ratio represented by TMG:NH₃ is preferably 1:400 to 1:16000, more preferably 1:400 to 1:1800 or 1:2000 to 1:16000, and still more preferably 1:2000 to 1:8000 from the viewpoint of reducing the C concentration.

The thickness in the c-axis direction of the i-GaN layer in the GaN buffer layer is the same as that described in the present embodiment of [GaN Epitaxial Substrate] in the above second aspect, and is preferably 50 nm to 900 nm. Here, the above thickness is preferably 50 nm or more from the viewpoint of normal device fabrication, and is preferably 900 nm or less from the viewpoint of reducing the leakage current.

### •Method for Forming Nitride Semiconductor Barrier Layer

After the above epitaxial GaN buffer layer is formed, a nitride semiconductor barrier layer may be formed. In the case where the GaN epitaxial substrate according to the present embodiment in the second aspect is used for the HEMT, it is required to form a nitride semiconductor barrier layer to generate a 2DEG. A preferred example of the barrier layer is an AlₓGa₁₋ₓN (0 < x < 1) layer, and may be an AlInGaN layer. The 2DEG is generated in a region sandwiched between the GaN buffer layer and the nitride semiconductor barrier layer.

The method for forming the nitride semiconductor barrier layer is not particularly limited, and a commonly known method may be adopted. Preferred examples include the MOCVD method and the MBE method.

A preferred thickness in the c-axis direction of the nitride semiconductor barrier layer on the GaN buffer layer is the same as that described in the present embodiment of [GaN Epitaxial Substrate] in the above second aspect.

In the case where the above nitride semiconductor barrier layer is formed, a commonly known layer such as a GaN cap layer can be formed by a commonly known method as necessary.

### Examples

The present invention will be described in detail below with reference to Examples, but the present invention is not limited to thereto.

### [Example 1]

A GaN buffer layer was deposited by the MOCVD method on a C-plane GaN substrate having a Fe-doped layer obtained by the HVPE method to obtain a GaN epitaxial substrate having a HEMT structure. A thickness of the entire C-plane GaN substrate in the c-axis direction was 400 µm, and among them, the Fe-doped layer was present on a Ga polar plane side with a thickness of about 100 µm. A Fe concentration of the Fe-doped layer was 2.2 × 10¹⁸ atoms/cm³.

In the formation of the GaN buffer layer, specifically, the C-plane GaN substrate was set in an MOCVD device, heated to 1090°C in a hydrogen/nitrogen mixed gas atmosphere and at atmospheric pressure, and supplied with trimethylgallium (TMG) and NH₃ gas. The gas supply rate was set such that TMG was 410 µmol / min and NH₃ gas was 5 slm. By performing crystal growth for 2.7 minutes under such conditions, a C-containing region having a C concentration of 1 × 10¹⁷ atoms/cm³ in the GaN buffer layer was formed. A thickness of the C-containing region was 300 nm. The total time of heating at 1090°C was 17 minutes.

Next, an i-GaN layer for which the supply rate of TMG and NH₃ gas and growth time, that is, a gas supply amount, was changed was grown to 200 nm on the obtained C-containing region. Further, as a nitride semiconductor barrier layer, an AlₓGa₁₋ₓN (0 < x < 1) layer having a thickness of 18 nm and a GaN cap layer having a thickness of 2 nm were grown on the i-GaN layer.

In this manner, a GaN epitaxial substrate having a HEMT structure was obtained. In the obtained GaN epitaxial substrate according to the first embodiment, a C-containing layer was present in the GaN buffer layer. Regarding the second embodiment, a Fe diffusion-restricting layer containing C was present in the GaN buffer layer. The C-containing layer or the Fe diffusion-restricting layer was present in the GaN buffer layer that is present in the [0001] axis direction relative to the Fe-doped layer.

### [Evaluation of GaN Epitaxial Substrate]

An SIMS measurement was performed on the GaN epitaxial substrate obtained in Example 1. In the GaN epitaxial substrate, a Fe concentration profile at an interface between the Fe-doped layer having a high Fe concentration and the C-containing region is shown by a solid line in FIG. 1. FIG. 3 is a Fe concentration profile in which the Fe concentration represented by the vertical axis in FIG. 1 is expressed in logarithm, and results of Example 1 are shown by a solid line as in FIG. 1.

As a result, regarding the first aspect and the second aspect, a distance from a measurement point at which the Fe concentration is 1/100 of that of the Fe-doped layer having the Fe concentration of 2.2 × 10¹⁸ atoms/cm³ in the GaN epitaxial substrate (that is, 2.2 × 10¹⁶ atoms/cm³) to the Fe-doped layer is 0.122 µm. A distance from a measurement point at which the Fe concentration is 1/10 of the Fe-doped layer (that is, 2.2 × 10¹⁷ atoms/cm³) was 0.045 µm. The measurement point at which the Fe concentration was 1/100 of the Fe-doped layer and the measurement point at which the Fe concentration was 1/10 of the Fe-doped layer were both positioned in the C-containing region.

Regarding the second aspect, the GaN substrate included the Fe-doped layer, the GaN buffer layer included the C-containing layer, the Fe-doped layer had a Fe concentration of 2.2 × 10¹⁸ atoms/cm³, and the C-containing layer had a C concentration of 1 × 10¹⁷ atoms/cm³. The Fe concentrations of regions present in the C-containing layer and in the [0001] axis direction relative to the C-containing layer, that is, the GaN regions were each less than 1 × 10¹⁷ atoms/cm³.

### [Comparative Example 1]

A GaN epitaxial substrate was obtained by growing a GaN buffer layer having no C-containing region by the HVPE method using a C-plane GaN substrate having a Fe-doped layer, which was the same as the C-plane GaN substrate in Example 1 except that the Fe concentration of the Fe-doped layer was 1.2 × 10¹⁸ atoms/cm³.

Specifically, ammonia and gallium chloride were supplied while maintaining a reactor temperature at 1090°C, thereby growing an undoped GaN buffer layer with a thickness of 5.5 µm on the C-plane GaN substrate. The growth rate was 50 µm/hr. Growth conditions were as follows: a reactor pressure of 101 kPa; an ammonia partial pressure of 3.172 kPa; a GaCl partial pressure of 0.847 kPa; a hydrogen gas partial pressure of 43.4 kPa; and a nitrogen gas partial pressure of 55.581 kPa. Thereafter, the supply of gallium chloride was stopped while maintaining the same temperature. When the total time of growth and retention reached 60 minutes, the heating for the reactor was stopped, and the reactor temperature was lowered to room temperature.

In this manner, a GaN epitaxial substrate was obtained.

The SIMS measurement was performed on the obtained GaN epitaxial substrate, and the result was shown by a solid line in FIG. 2. Based on this result, the diffusion constant of Fe in the GaN crystal having no C-containing region at 1090°C was determined.

The reason why the HVPE method is used instead of the MOCVD method as the growth method used for determining the diffusion constant is as follows. In the MOCVD method, as shown in Example 1, TMG is preferably used as a Group III material. Unintended carbon derived from an alkyl group in TMG is incorporated into the GaN crystal. This carbon inhibits Fe diffusion as described below with reference to FIGS. 1 and 3, and therefore, the diffusion constant of Fe in the GaN crystal cannot be accurately estimated. On the other hand, a raw material containing a carbon source including a Group III raw material is not used in the HVPE method, and therefore, the diffusion constant of Fe in a pure GaN crystal can be estimated.

To determine the diffusion constant of Fe, fitting of the SIMS measurement result of Comparative Example 1 was performed using the diffusion equation. The diffusion time was 60 minutes. Accordingly, the diffusion constant of Fe in the GaN crystal at 1090°C was determined to be 0.00005 µm²/min. The fitting result using the above diffusion equation is as indicated by the broken line in FIG. 2.

In the case of Comparative Example 2, a GaN epitaxial substrate having a HEMT structure was obtained using this diffusion constant value according to the MOCVD method as in the case of the GaN epitaxial substrate in Example 1 except that the C-containing region having a C concentration of 1 × 10¹⁷ atoms/cm³ was not formed, and a Fe concentration profile of Comparative Example 2 was calculated by the diffusion equation. The diffusion time was 17 minutes, which was the same as the time required for MOCVD growth in Example 1. The results are shown by broken lines in FIGS. 1 and 3.

As a result, it is understood that Fe is diffused much more in Comparative Example 2 than in Example 1. That is, the C-containing region containing C in the GaN buffer layer restricts the diffusion of Fe. Based on FIGS. 1 and 3, in the GaN epitaxial substrate of Comparative Example 2, assuming that there is a Fe-doped layer having a Fe concentration of 2.2 × 10¹⁸ atoms/cm³, a distance from a point at which the Fe concentration is 1/100 of the Fe concentration of the Fe-doped layer (that is, 2.2 × 10¹⁶ atoms/cm³), to the Fe-doped layer was 0.24 µm. A distance from a point at which the Fe concentration was 1/10 of the Fe concentration of the Fe-doped layer (that is, 2.2 × 10¹⁷ atoms/cm³), to the Fe-doped layer was 0.18 µm.

Although the present invention has been described in detail with reference to the specific embodiment, it will be apparent to those skilled in the art that various changes and modifications can be made without departing from the spirit and scope of the present invention. The present application is based on a Japanese Patent Application (No. 2022-039628) filed on March 14, 2022, and a Japanese Patent Application (No. 2022-039629) filed on March 14, 2022, contents of which are incorporated herein by reference.

## Claims

1. A GaN epitaxial substrate comprising:
a GaN substrate; and
a GaN buffer layer epitaxially grown on the GaN substrate,
wherein the GaN epitaxial substrate includes a point A and a point B which is positioned on a straight line parallel to a [0001] axis passing through the point A, the point B being present in a [0001] axis direction relative to the point A,
the point A is present in the GaN substrate or the GaN buffer layer,
the point B is present in the GaN buffer layer,
a ratio ([Fe]_{B}/[Fe]_{A}) is 1/100, [Fe]_{A} being a Fe concentration of the point A and [Fe]_{B} being a Fe concentration of the point B, and
a distance between the point A and the point B is 0.2 µm or less.

2. A GaN epitaxial substrate comprising:
a GaN substrate; and
a GaN buffer layer epitaxially grown on the GaN substrate,
wherein the GaN epitaxial substrate includes a point A' and a point B' which is positioned on a straight line parallel to a [0001] axis passing through the point A', the point B' being present in a [0001] axis direction relative to the point A',
the point A' is present in the GaN substrate or the GaN buffer layer,
the point B' is present in the GaN buffer layer,
a ratio ([Fe]_{B'}/[Fe]_{A'}) is 1/10, [Fe]_{A'} being a Fe concentration of the point A' and [Fe]_{B'} being a Fe concentration of the point B', and
a distance between the point A' and the point B' is 0.1 µm or less.

3. A GaN epitaxial substrate comprising:
a GaN substrate; and
a GaN buffer layer epitaxially grown on the GaN substrate,
wherein the GaN epitaxial substrate includes a point A" and a point B" which is positioned on a straight line parallel to a [0001] axis passing through the point A", the point B" being present in a [0001] axis direction relative to the point A",
the point A" is present in the GaN substrate or the GaN buffer layer,
the point B" is present in the GaN buffer layer,
a Fe concentration of the point A" is 1 × 10¹⁷ atoms/cm³ or more,
a Fe concentration of the point B" is 1 × 10¹⁵ atoms/cm³ or less, and
a distance between the point A" and the point B" is 0.2 µm or less.

4. A GaN epitaxial substrate comprising:
a GaN substrate; and
a GaN buffer layer epitaxially grown on the GaN substrate,
wherein the GaN epitaxial substrate includes a point A‴ and a point B‴ which is positioned on a straight line parallel to a [0001] axis passing through the point A‴, the point B‴ being present in a [0001] axis direction relative to the point A‴,
the point A‴ is present in the GaN substrate or the GaN buffer layer,
the point B‴ is present in the GaN buffer layer,
a Fe concentration of the point A‴ is 1 × 10¹⁷ atoms/cm³ or more,
a Fe concentration of the point B‴ is 1 × 10¹⁶ atoms/cm³ or less, and
a distance between the point A‴ and the point B‴ is 0.1 µm or less.

5. The GaN epitaxial substrate according to claim 1 or 2,
wherein the [Fe]a or the [Fe]_{A'} is 1 × 10¹⁷ atoms/cm³ or more.

6. The GaN epitaxial substrate according to any one of claims 1 to 5,
wherein the point A, the point A', the point A", or the point A‴ is present in the GaN substrate.

7. The GaN epitaxial substrate according to any one of claims 1 to 6,
wherein the GaN buffer layer includes a C-containing region having a C concentration of 1 × 10¹⁶ to 1 × 10¹⁸ atoms/cm³, and
the C-containing region includes the point B, the point B', the point B", or the point B‴, or is positioned closer to a (000-1) plane than a plane including the point B, the point B', the point B", or the point B‴, the plane being parallel to a (0001) plane.

8. The GaN epitaxial substrate according to any one of claims 1 to 7,
wherein at least one of the GaN substrate and the GaN buffer layer includes a Fe-doped layer obtained by doping with Fe.

9. The GaN epitaxial substrate according to any one of claims 1 to 8,
wherein the GaN substrate includes the Fe-doped layer obtained by doping with Fe, and
the point A, the point A', the point A", or the point A‴ is present in the Fe-doped layer.

10. The GaN epitaxial substrate according to any one of claims 7 to 9,
wherein the GaN buffer layer has an i-GaN layer in the [0001] axis direction relative to the C-containing region.

11. The GaN epitaxial substrate according to any one of claims 1 to 10, further comprising:
a nitride semiconductor barrier layer on the GaN buffer layer.

12. A GaN epitaxial substrate comprising:
a GaN substrate; and
a GaN buffer layer epitaxially grown on the GaN substrate,
wherein at least one of the GaN substrate and the GaN buffer layer includes a Fe-doped layer obtained by doping with Fe,
the GaN buffer layer includes a C-containing layer, and
the C-containing layer is present in a [0001] axis direction relative to the Fe-doped layer, and has a C concentration of 1 × 10¹⁶ to 1 × 10¹⁸ atoms/cm³.

13. A GaN epitaxial substrate comprising:
a GaN substrate; and
a GaN buffer layer epitaxially grown on the GaN substrate,
wherein the GaN substrate or the GaN buffer layer includes a Fe-doped layer obtained by doping with Fe,
the GaN buffer layer includes a Fe diffusion-restricting layer configured to restrict diffusion of Fe,
the Fe diffusion-restricting layer is present in an [0001] axis direction relative to the Fe-doped layer, and the Fe diffusion-restricting layer contains C.

14. The GaN epitaxial substrate according to claim 13,
wherein the Fe diffusion-restricting layer has a C concentration of 1 × 10¹⁸ atoms/cm³ or less.

15. The GaN epitaxial substrate according to any one of claims 12 to 14,
wherein the GaN substrate includes the Fe-doped layer.

16. The GaN epitaxial substrate according to any one of claims 12 to 15,
wherein the Fe concentration of the Fe-doped layer is 1 × 10¹⁷ atoms/cm³ or more.

17. The GaN epitaxial substrate according to any one of claims 12 to 16,
wherein the C-containing layer or the Fe diffusion-restricting layer is a layer doped with C.

18. The GaN epitaxial substrate according to any one of claims 12 to 17,
wherein a GaN region positioned in the C-containing layer or the Fe diffusion-restricting layer or in the [0001] axis direction relative to the C-containing layer or the Fe diffusion-restricting layer in the GaN buffer layer has a Fe concentration of less than 1 × 10¹⁷ atoms/cm³.

19. The GaN epitaxial substrate according to any one of claims 12 to 18,
wherein the GaN substrate or the GaN buffer layer includes a point A,
the GaN buffer layer includes a point B positioned on a straight line parallel to a [0001] axis passing through the point A, the point B being present in the [0001] axis direction relative to the point A,
a ratio ([Fe]_{B}/[Fe]_{A}) is 1/100, [Fe]abeing a Fe concentration of the point A, and [Fe]_{B} being a Fe concentration of the point B, and
a distance between the point A and the point B is 0.2 µm or less.

20. The GaN epitaxial substrate according to any one of claims 12, 15 to 19,
wherein the GaN buffer layer has an i-GaN layer in the [0001] axis direction relative to the C-containing layer.

21. The GaN epitaxial substrate according to any one of claims 12 to 20, further comprising:
a nitride semiconductor barrier layer on the GaN buffer layer.
